# EUROPEAN PATENT APPLICATION

(11) **EP 4 646 079 A1**
(43) Date of publication of application: **05.11.2025**
(21) Application number: 25172477.9
(22) Date of filing: 25.04.2025
(51) Int. Cl.: H10K 59/121, H10K 59/131, H10K 59/35, H10K 59/65

(54) **DISPLAY DEVICE, PHOTOELECTRIC CONVERSION DEVICE, AND ELECTRONIC APPARATUS**

(30) Priority: 30.04.2024 JP 2024074108
(71) Applicant: CANON KABUSHIKI KAISHA, Tokyo 146-8501 (JP)
(72) Inventor: YAMAMOTO, Tetsuro, Tokyo (JP); INUI, Fumihiro, Tokyo (JP); AKIYAMA, Takahiro, Tokyo (JP); MUTO, Takashi, Tokyo (JP); MAEKAWA, Shintaro, Tokyo (JP); KOMAZAWA, Akihito, Tokyo (JP); KUSUHARA, Ryusei, Tokyo (JP)
(74) Representative: WESER & Kollegen Patentanwälte PartmbB

(57) **Abstract**

A display device includes scanning lines; signal lines; and a display region in which pixels are two-dimensionally arranged. The pixels include a light-emitting element and a pixel driving circuit, the light-emitting element includes a light-emitting unit in which an organic layer having a light-emitting layer is sandwiched between a first electrode and a second electrode, and the pixel driving circuit includes a writing transistor and a driving transistor, the pixels include a first pixel and a second pixel disposed at a position closer to a center of the display region than the first pixel, and a ratio of an area of a driving region of the first pixel to an area of a driving region of the second pixel is greater than a ratio of an area of one light emitting unit of the first pixel to an area of one light emitting unit of the second pixel.

## Description

### BACKGROUND OF THE INVENTION

### Field of the Invention

The present disclosure relates to a display device, a photoelectric conversion device, and an electronic apparatus, and in particular to a planar (flat-panel) display device, a photoelectric conversion device, and an electronic apparatus in which pixels including electro-optical elements are arranged two-dimensionally in a matrix.

### Description of the Related Art

In recent years, in the field of display devices that display images, flat-panel display devices in which pixels including light-emitting elements (hereinafter sometimes referred to as "pixel driving circuits") are arranged two-dimensionally in a matrix have rapidly become widespread. One type of flat-panel display device is a display device that uses so-called current-driven electro-optical elements, whose emission luminance changes depending on the current value flowing through the device, as the light-emitting elements of the pixels. As a current-driven electro-optical element, an organic EL (Electro Luminescence) element is known that utilizes the phenomenon that light is emitted when an electric field is applied to an organic thin film.

Organic EL display devices using organic EL elements as pixel light-emitting elements have the following features. Organic EL elements consume low power because they can be driven with an applied voltage of 10 V or less. Since organic EL elements are self-luminous elements, they provide higher image visibility compared to liquid crystal display devices that display images by controlling the light intensity from a light source for each pixel with liquid crystal. Additionally, they can be easily made lighter and thinner because they do not require a light source such as a backlight. In addition, the response speed of organic EL elements is very fast, about several µ sec, so afterimages when displaying moving images are suppressed to a level that is not noticeable to the human eye.

Organic EL display devices can be driven by either a simple (passive) matrix method or an active matrix method, just like liquid crystal display devices. However, although simple matrix display devices have a simple structure, they have problems such as the difficulty of realizing large, high-definition display devices because the emission period of the electro-optical elements decreases with an increase in the number of scanning lines (i.e., the number of pixels).

Therefore, in recent years, active matrix display devices have been actively developed in which the current flowing through the electro-optical element is controlled by an active element, such as an insulated gate field-effect transistor, provided in the same pixel as the electro-optical element. In active matrix display devices, the electro-optical element continues to emit light over the period of one frame, making it easy to realize large, high-definition display devices.

In recent years, the display region has become increasingly higher in definition in virtual reality (VR) systems, augmented reality (AR) systems, and other display systems that use organic EL elements as electro-optical elements. As the display region becomes higher in definition and resolution, the amount of display image data increases, requiring a faster transmission speed and also increasing power consumption.

As a countermeasure to this, for example, a layout can be adopted in which the central part of the display region is composed of high-definition pixels, while the other parts are composed of low-definition pixels. Accordingly, a method is available that reduces the amount of display image data compared to the conventional method in which the entire display region is composed of high-definition pixels, thereby providing advantages in terms of transmission speed and power consumption.

For example, such methods are proposed in JP-A-2003-162236, JP-A-2013-117553, and Japanese Translation of PCT Application No. 2019-507380.

In this method, since a single pixel region is large in a low-definition pixel, the area of the light-emitting unit of the organic EL element is generally made larger than that of a high-definition pixel region. However, the characteristics of the organic EL element depend on its film thickness, and for example, if the film thickness distribution is different even within one light-emitting unit, the characteristics will change. Therefore, there is a problem that the characteristics of the organic EL element, such as the emission efficiency and lifespan, differ between the central part and the other parts of the display region.

### SUMMARY OF THE INVENTION

In some embodiments of the present disclosure, the difference in characteristics, such as the emission efficiency and lifespan of the organic EL elements, in the display region can be reduced, and image quality defects, such as unevenness and burn-in, can be suppressed.

According to some embodiments, it is provided a display device as specified in claims 1 to 21. In addition, it is provided a photoelectric conversion device as specified in claim 22. In addition, it is provided an electronic apparatus as specified in claim 23.

Further features of various embodiments will become apparent from the following description of exemplary embodiments with reference to the attached drawings.

### BRIEF DESCRIPTION OF THE DRAWINGS

FIG. 1 is a schematic diagram showing a display device according to a first embodiment;
FIGS. 2A and 2B are examples of the arrangement of a pixel driving circuit and a light-emitting unit according to the first embodiment;
FIGS. 3A and 3B are examples of circuit diagrams of a pixel according to the first embodiment;
FIG. 4 is an example of a planar arrangement of a pixel driving circuit according to the first embodiment;
FIG. 5 is an example of a cross-sectional view of an organic EL element according to the first embodiment;
FIG. 6 is an example of the arrangement of a pixel driving circuit and a light-emitting unit according to the first embodiment;
FIG. 7 is an example of the arrangement of a pixel driving circuit and a light-emitting unit according to the first embodiment;
FIG. 8 is an example of the arrangement of a pixel driving circuit and a light-emitting unit according to the first embodiment;
FIG. 9 is an example of the arrangement of a pixel driving circuit and a light-emitting unit according to the first embodiment;
FIG. 10 is an example of the arrangement of a pixel driving circuit and a light-emitting unit according to the first embodiment;
FIG. 11 is an example of the arrangement of a pixel driving circuit and a light-emitting unit according to a second embodiment;
FIG. 12 is a comparative example of the arrangement of a pixel driving circuit and a light-emitting unit according to the second embodiment;
FIG. 13 is a schematic diagram showing an active matrix display device according to a third embodiment;
FIG. 14 is an example of the arrangement of a pixel driving circuit and a light-emitting unit according to the third embodiment;
FIG. 15 is an example of a timing waveform diagram of the display device according to the third embodiment;
FIG. 16 is an example of a cross-sectional view of the display device according to the first to third embodiments;
FIG. 17 is an example of a schematic cross-sectional view of a pixel of the display device according to the first to third embodiments;
FIG. 18 is a schematic diagram showing an example of a display device according to a fourth embodiment;
FIGS. 19A and 19B are schematic diagrams showing an example of an imaging device and the like according to a fifth embodiment;
FIGS. 20A and 20B are schematic diagrams showing an example of an electronic apparatus according to a sixth embodiment;
FIGS. 21A and 21B are schematic diagrams showing an example of a wearable device according to a seventh embodiment; and
FIGS. 22A and 22B are schematic diagrams showing an example of an image observation device according to an eighth embodiment.

### DESCRIPTION OF THE EMBODIMENTS

### First Embodiment

Embodiments of the display device according to the present disclosure will be described with reference to the drawings. The following embodiments are merely examples, and some embodiments are not limited to numerical values, shapes, materials, components, arrangement of components, and connection forms.

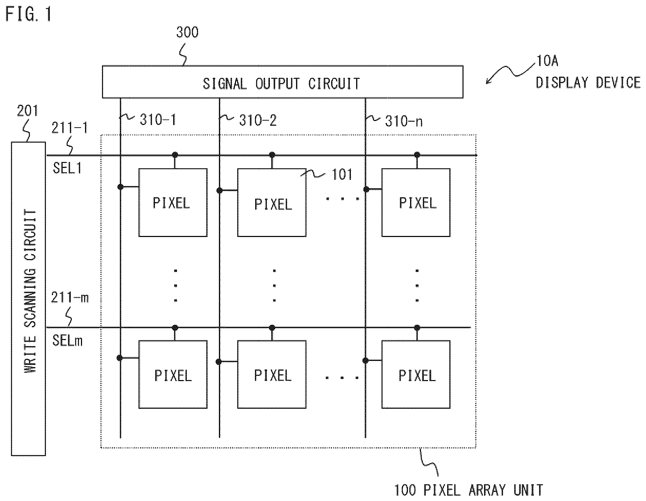

FIG. 1 is a schematic diagram (a plan view of the main surface of the substrate) showing an example of a display device according to the first embodiment. A display device 10A has a pixel array unit 100 and a driving unit arranged around the pixel array unit 100. The pixel array unit 100 has a plurality of pixels 101 arranged two-dimensionally across a plurality of rows and a plurality of columns.

The driving unit for the pixels 101 includes, for example, a scanning driving system consisting of a write scanning circuit 201 and a signal supply system consisting of a signal output circuit 300. In FIG. 1, the write scanning circuit 201 is arranged on the left side of the pixel array unit 100. However, the layout is not limited to this. The write scanning circuit 201 may be disposed on the right side of the pixel array unit 100, or a layout configuration in which the write scanning circuit 201 is disposed on both the left and right sides of the pixel array unit 100 may be adopted.

Regarding pixels, generally, one pixel is composed of a plurality of subpixels, and these subpixels correspond to the pixel 101. More specifically, one pixel is composed of three subpixels, for example, a subpixel that emits red (R) light, a subpixel that emits green (G) light, and a subpixel that emits blue (B) light. These color lights may be referred to as a first color light, a second color light different from the first color light, and a third color light different from the first color light and the second color light. However, one pixel is not limited to a combination of subpixels of the three primary colors of RGB. In other words, one pixel may be composed of subpixels of one or more colors in addition to the subpixels of the three primary colors. More specifically, for example, a pixel may be configured by adding a subpixel that emits white (W) light to improve luminance, or by adding at least one subpixel that emits complementary light to expand the color reproduction range.

In the pixel array unit 100, a plurality of first scanning lines (hereinafter also referred to as write scanning lines) 211-1 to 211-m extending in the row direction (also referred to as the first direction) are wired for each pixel row for the arrangement of pixels 101 in m rows and n columns. In addition, a plurality of signal lines 310-1 to 310-n extending in the column direction (arrangement direction of pixel rows: direction intersecting the first direction, sometimes referred to as the second direction) are wired for each pixel column.

The first scanning lines 211-1 to 211-m are connected to output terminals of the corresponding rows of the write scanning circuit 201, respectively. The signal lines 310-1 to 310-n are connected to the output terminals of the corresponding columns of the signal output circuit 300.

The pixel array unit 100 is generally formed on a Si substrate for high-definition AR or VR applications, but is not limited to this. For example, the pixel array unit 100 may be formed on a transparent insulating substrate, such as a glass substrate.

The write scanning circuit 201 is composed of a shift register that shifts (transfers) a start pulse (not shown) in sequence in synchronization with a clock pulse (not shown). This write scanning circuit 201 writes a video signal to each pixel 101 of the pixel array unit 100. At that time, write scanning signals SEL (SEL_1 to SEL_m) are sequentially supplied to the first scanning lines 211-1 to 211-m whereby the pixels 101 of the pixel array unit 100 are scanned row by row in order (line-sequential scanning).

The signal output circuit 300 outputs a signal potential (hereinafter, sometimes simply referred to as "signal voltage") Vsig of a video signal corresponding to luminance information supplied from a signal supply source (not shown). For example, a well-known time-division driving circuit can be used as the signal output circuit 300. The time-division driving method is also called a selector method, and assigns a plurality of signal lines as a unit (group) to one output terminal of a driver (not shown) which is a signal supply source. Then, the plurality of signal lines are selected sequentially in a time-division manner. On the other hand, the method drives each signal line by distributing and supplying the video signals output in a time series for each output terminal of the driver to the selected signal lines in a time-division manner.

As an example, in the case of color display, three adjacent pixel columns of R, G, and B are used as a unit, and the R, G, and B video signals are input to the signal output circuit 300 in a time series from the driver within one horizontal period. The signal output circuit 300 is composed of multiplexers (selection switches) provided corresponding to three pixel columns of R, G, and B, and the multiplexers are sequentially turned on in a time-division manner to write the R, G, and B video signals to the corresponding signal lines in a time-division manner.

Here, the three pixel columns (signal lines) of R, G, and B are used as a unit, but the some embodiments are not limited to this. For example, three subpixels of the same color may be used as a unit. In addition, by adopting this time-division driving method (selector method), if the number of time-divisions is x (x is an integer of 2 or more), the number of driver outputs and the number of wirings between the driver and the signal output circuit 300 can be advantageously reduced to 1/x of the number of signal lines.

The signal voltage Vsig output from the signal output circuit 300 is written row by row to each pixel 101 of the pixel array unit 100 via the signal lines 310-1 to 310-n (line-sequential writing).

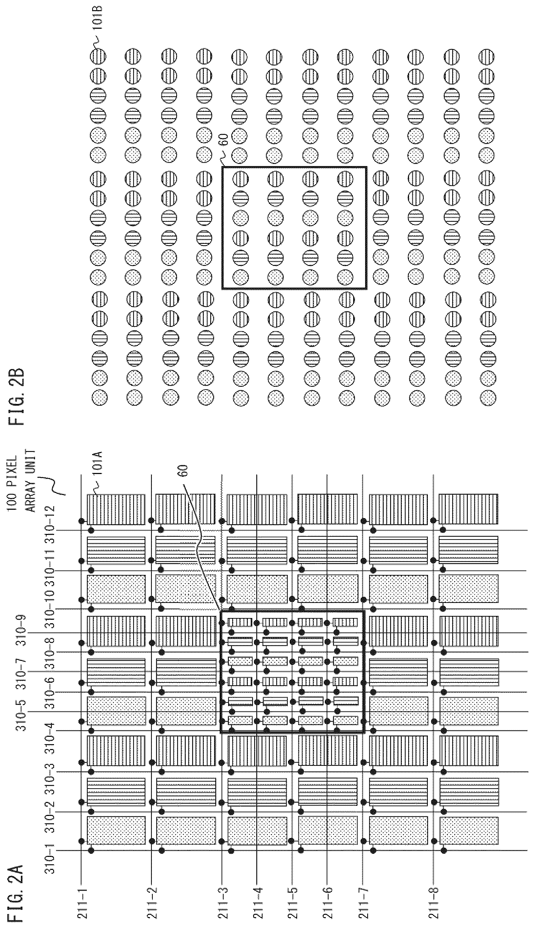

Next, an example of the arrangement of the pixels 101 in the pixel array unit 100 described above will be described. FIG. 2A is an example of a plan view of the arrangement of the pixel driving circuit 101A constituting the pixel 101. FIG. 2B is an example of a plan view of the arrangement of the light-emitting unit 101B of the light-emitting element constituting the pixel 101 (the light-emitting unit will be described later). In FIGS. 2A and 2B, as an example, the pixel arrangement of a display device in which one pixel is composed of three subpixels is described. The dot pattern indicates the pixel driving circuit and the light-emitting unit of the light-emitting element that emits red (R) light. The vertical stripe pattern indicates the pixel driving circuit and the light-emitting unit of the light-emitting element that emits green (G) light. The horizontal stripe pattern indicates the pixel driving circuit and the light-emitting unit of the light-emitting element that emits blue (B) light.

As shown in FIG. 2A, compared to the pitch of the six signal lines 310-4 to 310-9 located in the central part 60 of the pixel array unit 100 (hereinafter, also referred to as the display region central part 60), the pitch of the three signal lines 310-1 to 310-3 and 310-10 to 310-12 on the left and right sides is wider. Similarly, compared to the pitch of the four rows of write scanning lines 211-3 to 211-6 located in the central part 60 of the pixel array unit 100, the pitch of the two rows of write scanning lines 211-1, 211-2 and 211-7, 211-8 on the upper and lower sides is wider. In this way, it is possible to reduce the number of signal lines and scanning lines compared to when pixel driving circuits of the same size as the display region central part 60 are arranged in an array shape over the entire display region, that is, when the entire display region is composed of high-definition pixels as in the conventional case. In this way, it is possible to reduce the amount of display image data, which is advantageous over the conventional case in terms of transmission speed and power consumption. Note that a pixel located at the central part of the display region may be referred to as a second pixel, and a pixel located at the peripheral part of the display region may be referred to as a first pixel. That is, the second pixel is disposed closer to the center of the display region than the first pixel. The second pixel may be disposed, for example, at a distance of 5% or less from the center of the display region (the distance from the center to the edge is taken as 100%). The first pixel may be disposed, for example, at a distance of 25% or less from the edge of the display region (the distance from the edge to the center is taken as 100%).

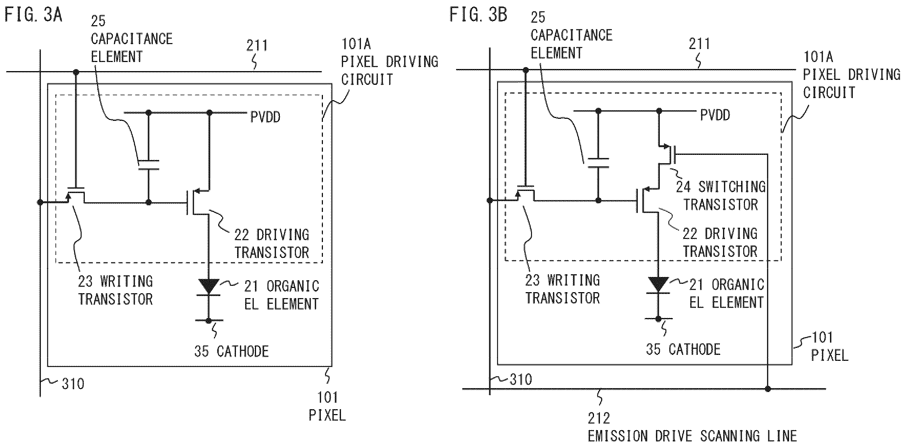

Next, the pixel driving circuit 101A will be described. FIG. 3A shows an example of the configuration of the pixel driving circuit 101A. In this figure, a pixel formed at the intersection of a write scanning line 211 and a signal line 310 generally includes a writing transistor 23, a driving transistor 22, and a capacitance element 25. Among them, the writing transistor 23 is connected between the signal line 310 and the gate electrode of the driving transistor 22. The gate electrode of the writing transistor 23 is connected to the write scanning line 211, and is turned on by the scanning signal of the write scanning line 211, and writes a signal voltage Vsig to the gate of the driving transistor 22. The driving transistor 22 supplies a current to the organic EL element 21 by the signal voltage written to the gate, and the organic EL element 21 emits light with a luminance according to the supplied current. The capacitance element 25 is provided between the gate electrode of the driving transistor 22 and a power supply PVDD, and plays a role of holding the written signal voltage. As shown in FIG. 3B, the pixel may have a configuration in which a switching transistor 24 is connected between the source electrode of the driving transistor and the power supply PVDD. Although not shown, an initialization transistor may be connected between the anode electrode of the organic EL element (sometimes called an organic light-emitting element) and a power supply having a lower potential than the power supply PVDD, or other configurations may be used.

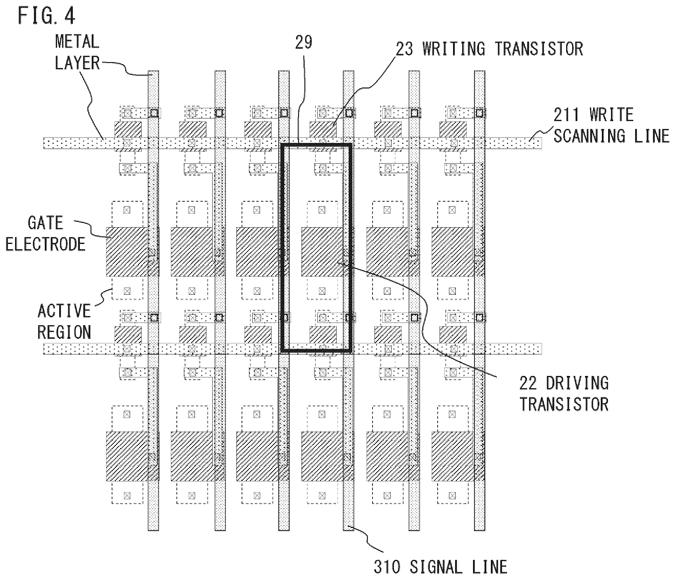

Next, the driving region of the pixel in this embodiment will be described. FIG. 4 is a schematic plan layout diagram of the pixel driving circuit shown in FIG. 3A. As shown in FIG. 4, in a certain pixel, which is a region 29 surrounded by a signal line 310 and a write scanning line 211 to which a writing transistor 23 is connected, a signal line to which a writing transistor of a pixel adjacent to the signal line 310 with the driving transistor 22 sandwiched therebetween is connected, and a write scanning line connected to a writing transistor of a pixel adjacent to the write scanning line 211 with the driving transistor 22 sandwiched therebetween is defined as a "driving region". Strictly speaking, although the region where the pixel driving circuit is arranged is different from the region 29 (driving region), since the pitch of the pixel driving circuit in the row direction and column direction is approximately equal to the pitch of the write scanning line and the signal line, the area of the pixel driving circuit is approximately equal to the area of the region 29 (driving region). In light of this definition, in FIG. 2A, the driving region of the pixel is larger in the peripheral part than in the central part 60 of the display region.

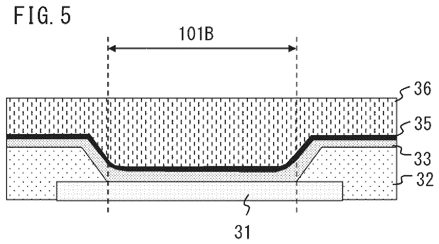

Next, the light-emitting unit will be described with reference to FIG. 5. In general, the organic EL element 21 has an anode electrode 31, which is a first electrode, and a cathode electrode 35, which is a second electrode facing the anode electrode. Here, the cathode electrode 35 is generally common to all display regions. As shown in FIG. 5, the anode electrode 31 typically has a structure in which the end of the anode electrode 31 is covered with an insulating film 32, a functional layer 33 (also called an organic layer) such as a light-emitting layer and a hole injection layer is formed thereon, the cathode electrode 35 is formed thereon, and the insulating film 36 is further formed thereon. In the structure, the anode electrode 31 emits light in a portion not covered by the insulating film 32 (inside the opening of the insulating layer). Hereinafter, the portion of the anode electrode 31 not covered by the insulating film 32 and where the functional layer 33 is directly sandwiched between the first electrode and the second electrode is referred to as a light-emitting unit 101B. The organic EL element 21 may have a structure in which a color filter or a microlens is formed on the insulating film 36 formed on the cathode electrode 35.

Next, the light-emitting unit in the display region will be described. As shown in FIG. 2B, the areas of one light-emitting unit 101B of the organic EL element in the central part 60 of the display region and in its peripheral part are drawn to be approximately equal. However, they do not necessarily need to be equal. It is sufficient that the ratio of the area of the driving region in the peripheral part (first pixel) to the area of the driving region in the central part 60 of the display region (second pixel) is greater than the ratio of the area of one light-emitting unit 101B in the peripheral part (first pixel) to the area of one light-emitting unit 101B in the central part 60 of the display region (second pixel). In other words, it is sufficient that the ratio of the area of one light-emitting unit to the area of the driving region (first pixel) in the peripheral part of the display region is smaller than the ratio of the area of one light-emitting unit to the area of the driving region (second pixel) in the central part 60 of the display region.

In addition, in FIG. 2B, the number of light-emitting units 101B in one pixel driving circuit is determined by the area of the driving region. In FIG. 2A, the light-emitting units are arranged such that if the area of the driving region in the central part 60 of the display region is 1, the area of the driving region in the peripheral part is 4. Accordingly, one light-emitting unit 101B is arranged in the central part 60 of the display region, and four light-emitting units 101B are arranged in the peripheral part.

The effects of this embodiment are described below. As described above, the light-emitting unit 101B of the organic EL element generally has a structure in which the end of the anode electrode 31 is covered with the insulating film 32 as shown in FIG. 5, and the functional layer 33, such as the light-emitting layer and the hole injection layer, which constitute the organic EL element 21, is formed on the entire surface of this structure in common. However, due to the structure, the thickness of the functional layer 33, which constitutes the organic EL element 21, differs between the center and the end (around the insulating film 32) of the light-emitting unit 101B. Generally, the current-voltage characteristics, emission efficiency, and life characteristics of an organic EL element vary depending on the film thickness of the functional layer. Therefore, the characteristics, such as the current-voltage characteristics, emission efficiency, and life characteristics, of the organic EL element differ between the center and the end of the light-emitting unit in one light-emitting unit due to the difference in film thickness. For this reason, in FIG. 2B, if the size and shape of the light-emitting unit 101B differs between the central part 60 of the display region and its peripheral part, the ratio of the central part to the end in one light-emitting unit will differ. As a result, differences occur in the characteristics of the organic EL elements, such as the emission efficiency and reliability characteristics, and defects such as image quality defects (e.g., luminance unevenness) and burn-in caused by differences in life characteristics between emission areas occur. Among image quality defects, the luminance unevenness can be corrected by adjusting the signal voltage for each display region, but burn-in caused by differences in life characteristics cannot be corrected because the characteristics cannot be predicted.

In contrast, in FIG. 2B, the size (area) of one light-emitting unit is approximately equal in the central part 60 of the display region and in its peripheral part. In addition, the number of light-emitting units is determined according to the size (area) of the driving region, so that the characteristic difference of the organic EL elements in the entire display region is reduced. For this reason, it is possible to predict the characteristics of the organic EL elements in the entire display region, and defects such as unevenness and burn-in as described above do not occur.

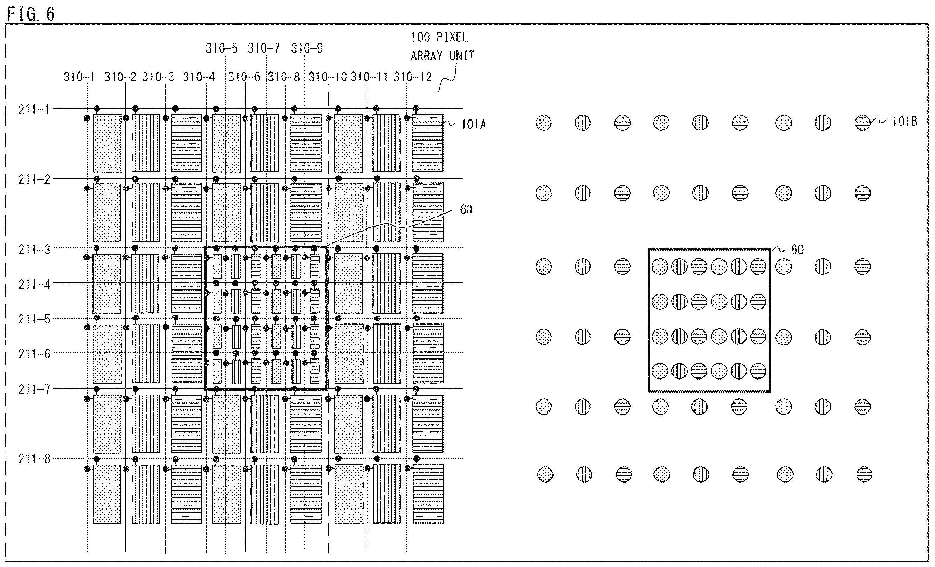

As described above, an example has been provided in which the number of light-emitting units corresponds to the area of the driving region. However, the number of light-emitting units does not necessarily have to be determined based on the area of the driving region. For example, as shown in FIG. 6, only one light-emitting unit 101B may be provided in the central part 60 of the display region and its peripheral part. In this case, it is sufficient that the ratio of the area of one light-emitting unit 101B in the peripheral part (first pixel) to the area of one light-emitting unit 101B in the central part 60 (second pixel) of the display region is smaller than the ratio of the area of the driving region of the peripheral part (first pixel) to the area of the driving region of the central part 60 (second pixel). Desirably, if the areas of the light-emitting units 101B in the central part 60 of the display region and in its peripheral part are the same, the characteristic difference of the light-emitting units 101B in the entire display region can be reduced. In this way, it is possible to predict the characteristics of the organic EL element, and by performing correction according to the life characteristics of the light-emitting unit 101B, image quality defects such as burn-in as described above do not occur.

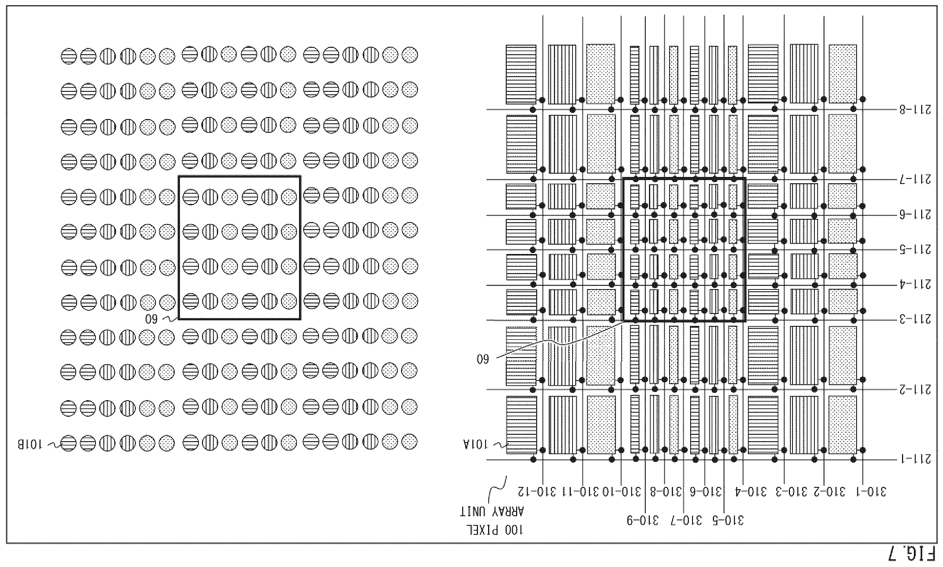

In the above, the arrangement and size of the pixel driving circuit and the light-emitting unit are described using FIGS. 2A and 2B as examples, but the arrangement of the pixel driving circuit and the light-emitting unit is not limited to this. For example, the arrangements shown in FIGS. 7, 8, 9, and 10 may be used. In any case, the number of signal lines or write scanning lines can be reduced in the entire display region compared to the case where pixels of the same size as those in the central part of the display region are arranged in an array, so that the driving power can be reduced.

FIG. 7 shows a configuration in which the pixel driving circuit 101A and the light-emitting unit 101B are arranged in the peripheral part of the display region in a different manner from the configuration shown in FIGS. 2A and 2B. In FIG. 7, when the number of driving units in the central part 60 of the display region is 1, the number of driving units at the top, bottom, left, and right of the central part of the display region is 2, and the number of driving units near the four corners of the display region is 4.

Accordingly, the number of light-emitting units per pixel driving circuit is 1 in the central part 60 of the display region, 2 at the top, bottom, left and right of the central part, and 4 near the four corners of the display region. By arranging the pixel driving circuit 101A as shown in FIG. 7, a configuration is achieved in which the color of a single subpixel is arranged continuously above and below the central part 60 of the display region. As a result, even when the display is not illuminated, the seam between the central part 60 of the display region and the upper and lower regions becomes less visible. As a result, a uniform image quality without brightness unevenness can be achieved when the display is illuminated.

Note that here, the driving region having the pixel driving circuit 101A connected to the write scanning lines 211-1 and 211-2 in FIG. 7 corresponds to the driving region above the central part of the display region. The driving region having the pixel driving circuit 101A connected to the write scanning lines 211-7 and 211-8 corresponds to the driving region below the central part of the display region. Meanwhile, the driving region having the pixel driving circuit 101A connected to the signal lines 310-1 to 310-3 in FIG. 7 corresponds to the driving region on the left of the central part of the display region. The driving region that has the pixel driving circuit 101A connected to the signal lines 310-10 to 310-12 corresponds to the driving region on the right of the central part of the display region.

To express the region above and below the central part of the display region in another way, for example, the display region is divided by three in the first direction (row direction) into a first region, a second region, and a third region between the first region and the second region. In addition, the region adjacent to the third region in the second direction (column direction) is the fourth region. In this case, the fourth region corresponds to the central part, and the third region corresponds to the region above or below the central part. The first pixel described above may be arranged in the first to third regions, and the second pixel may be arranged in the fourth region. As shown in FIG. 7, the pitch of the signal lines connected to the writing transistors of the pixels arranged in the third region including the first pixel is the same as the pitch of the signal lines connected to the writing transistors of the pixels arranged in the fourth region including the second pixel.

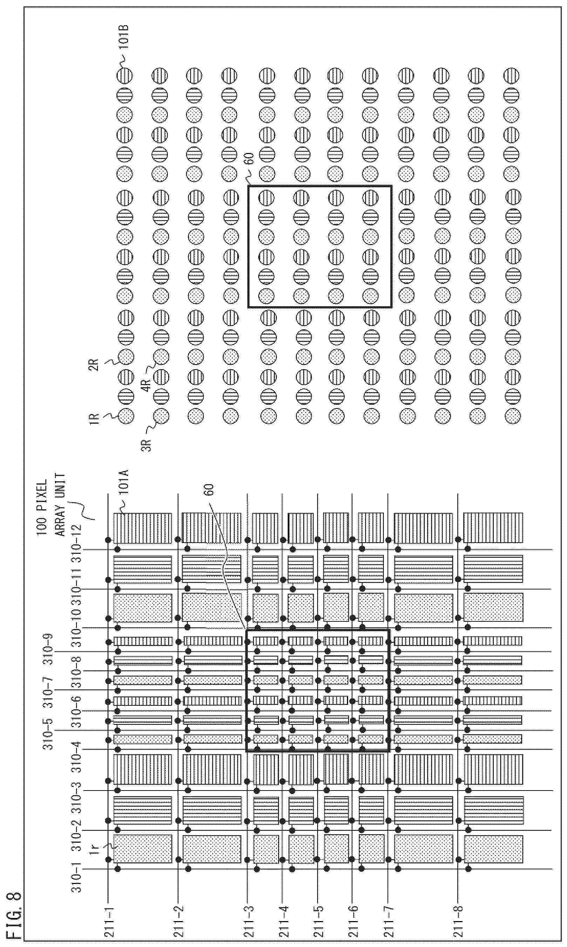

In FIG. 8, the arrangement of the pixel driving circuits 101A is the same as in FIG. 7, but the arrangement of the light-emitting units on the left and right of the central part of the display region is different from that in FIG. 7. Specifically, in the right diagram of FIG. 7, two light-emitting units of the same colors, red, red, green, green, blue, and blue, are arranged consecutively in the column direction. In contrast, in the right diagram of FIG. 8, light-emitting units of the same colors, red, green, blue, red, green, and blue, are arranged consecutively in the column direction, and the arrangement is the same as that of the central part 60 of the display region. The light-emitting units 1R, 2R, 3R, and 4R shown in FIG. 8 are connected to the same pixel driving circuit 1r. It may be preferable that the anode electrodes of these light-emitting units 1R, 2R, 3R, and 4R are connected to a wiring layer, but it is also possible to adopt a configuration in which at least one light-emitting unit is independent from the other light-emitting units and the independent light-emitting unit is connected to at least one driving transistor.

By arranging the light-emitting units as shown in FIG. 8, the light-emitting units 101B are arranged in the same manner as those in the central part 60 of the light-emitting region throughout the entire display region, so that the seams between the central part 60 of the light-emitting region and the left and right regions thereof are less visible. As a result, a uniform image quality without brightness unevenness can be achieved when the display is illuminated.

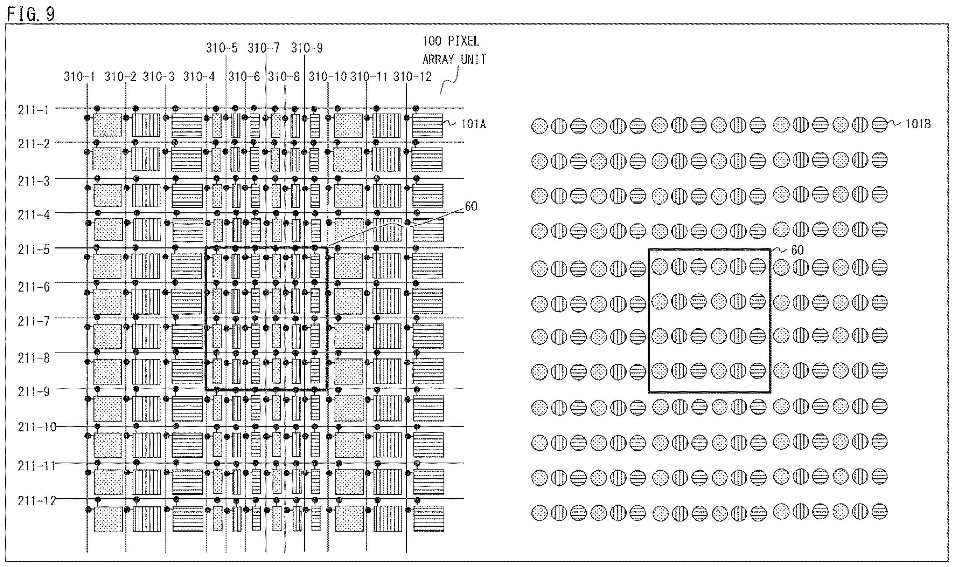

FIG. 9 adopts a configuration in which the arrangement of the light-emitting units is the same as in FIG. 8, but the arrangement of the pixel driving circuit 101A is different. In the arrangement of the pixel driving circuit shown in FIG. 9, there are two types of pixels in the display region: pixels connected to signal lines with a narrow pitch and pixels connected to signal lines with a wide pitch. The pixel circuit is arranged such that if the area of the driving region connected to the signal lines with a narrow pitch is 1, the area of the driving region connected to the signal lines with a wide pitch is 2. In addition, in the configuration of the pixel driving circuit shown in FIG. 9, the arrangement of the signal lines and the write scanning lines for the pixel driving circuits with the same driving region area is all the same. By adopting such a configuration, if the driving region area is the same, the parasitic capacitance existing between the signal lines and the write scanning lines and the pixel driving circuit can be made uniform, so that the occurrence of brightness unevenness due to the parasitic capacitance can be suppressed. In addition, in FIG. 9, the area of the central part 60 of the display region is the same as that of the driving regions above and below the central part, but the area of the driving regions on the left and right of the central part and near the four corners is at least larger than the area of the driving region of the central part 60. It can be said that this ratio is larger than the ratio of the area of the light-emitting unit 101B in the central part 60 of the display region to that in the peripheral part.

In FIG. 9, twelve write scanning lines (211-1 to 211-12) are wired. A plurality of lines of write scanning lines (211-1 to 211-4, 211-9 to 211-12) other than the write scanning lines 211-5 to 211-8 connected to the central part 60 of the display region may be driven simultaneously. By adopting such a configuration, the amount of display image data is further reduced, which is advantageous in terms of transmission speed and power consumption.

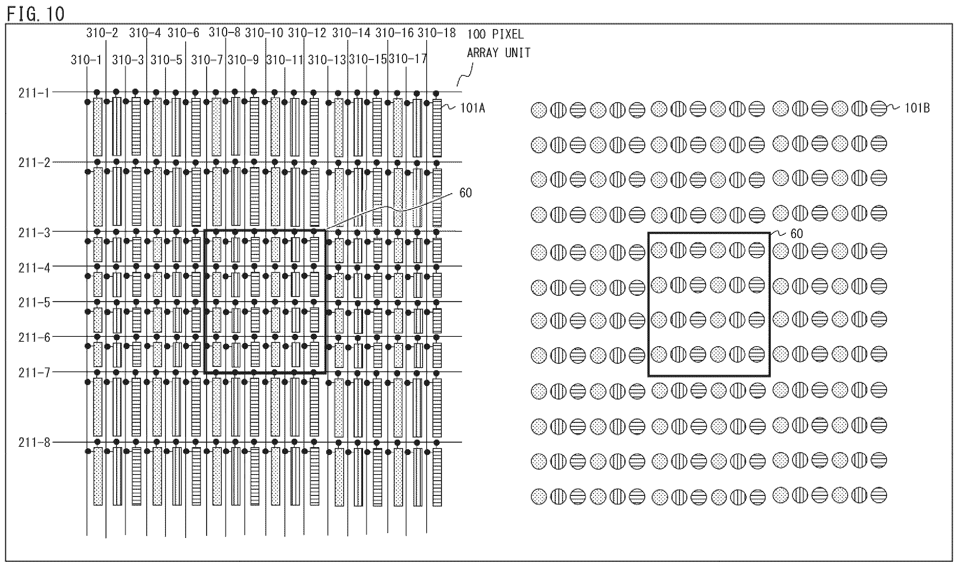

In FIG. 10, as in FIG. 9, the arrangement of the light-emitting unit is the same as in FIG. 8, but the arrangement of the pixel driving circuit 101A is different. In the configuration shown in FIG. 10, there are two types of pixels: those connected to write scanning lines with a narrow pitch and those connected to write scanning lines with a wide pitch. The pixel circuits are arranged such that if the area of the driving region connected to the write scanning lines with a narrow pitch is 1, the area of the driving region connected to the write scanning lines with a wide pitch is 2. In FIG. 10, as in FIG. 9, in the configuration of the pixel driving circuits, the arrangement of signal lines and write scanning lines for the pixel driving circuits of the same driving region is all the same. By adopting such a configuration, if the area of the driving region is the same, the parasitic capacitance existing between the signal lines and write scanning lines and the pixel driving circuit can be made uniform, so that the occurrence of brightness unevenness due to parasitic capacitance can be suppressed. In FIG. 10, as in FIG. 9, the areas of the driving regions in the central part 60 and the left and right of the center are the same, but the areas of the driving regions at the top and bottom of the center and near the four corners are at least larger than the area of the driving region in the central part 60. It can be said that this ratio is larger than the ratio of the areas of the light-emitting units 101B in the central part 60 and the peripheral parts of the display region.

In FIG. 10, eighteen signal lines (310-1 to 310-18) are wired, but the number of write scanning lines is 8. In the entire display region, the number of write scanning lines can be reduced compared to the case where a driving region having the same area as the central part of the display region is arranged in an array, so that the drive power can be reduced.

In addition, in FIG. 10, signal lines (310-1 to 310-6, 310-13 to 310-18) other than the signal lines 310-7 to 310-12 connected to the central part 60 of the display region may be driven simultaneously in a plurality of rows. By adopting such a configuration, the amount of display image data can be further reduced, which is advantageous in terms of transmission speed and power consumption.

**In** FIGS. 2A and 2B and FIGS. 6 to 12, the display region is divided into three in both the first direction (row direction) and the second direction (column direction), with the central region being the central part and the surrounding eight regions being the peripheral parts, but the display device of this embodiment is not limited to this. The ratio of the region occupied by the central part and the peripheral part can be set appropriately according to the design of each display device. For example, in a display device such as an immersive display, the central part of the visual field is made high-definition and the peripheral part is made low-definition to give a sense of realism. There are several known visual fields of humans: discrimination visual field (excellent visual function, capable of receiving high-definition information), effective visual field (capable of receiving targeted information instantly only by eye movement), induced visual field (low information discrimination ability but affects sense of direction), and auxiliary visual field (visual information can be recognized). Taking into account the characteristics of each of these visual fields, the central part where the second pixel is arranged may be set within a distance of 30% from the center of the display region, or even within a distance of 5% (the distance from the center to the edge is defined as 100%). The peripheral part where the first pixel is arranged may be within a distance of 25%, 50%, or 70% from the edge of the display region (the distance from the edge to the center is defined as 100%). Note that, here, an example is shown in which the display region has a central part where the second pixel is arranged and a peripheral part where the first pixel is arranged, but the display device of this embodiment is not limited to this. For example, the peripheral part may have a region where pixels having a larger driving region than the first pixel are arranged outside the region where the first pixel is arranged. **In** addition, a region where pixels having a smaller driving region than the first pixel are arranged may be arranged between the central part and the region where the first pixel is arranged. **In** addition, a region having so-called dummy pixels that do not contribute to display may be arranged between the display region and the driving portion. The above example is merely an example, and the arrangement of the pixel driving circuit and the light-emitting unit are not limited to those described above. The pixel driving circuit and the light-emitting unit may be arranged in an appropriate manner.

Next, the pixel driving circuit in the peripheral part of the display region will be described. Generally, the current value to be supplied through the organic EL element to obtain a certain brightness is determined according to the pixel size. For example, if the pixel size is four times larger, the current required to obtain the same brightness is four times larger. For this reason, it is desirable that the current driving capacity of a driving transistor is larger in the peripheral part than in the central part of a display region. For example, when the pixel size is four times larger, it is preferable that the current driving capacity of the driving transistor is four times larger.

**In** contrast, it is conceivable to make the signal voltage input to the pixel driving circuit in the peripheral part of the display region larger than that in the central part, so that the pixel driving circuit in the peripheral part of the display region can supply a large current. However, if the signal voltage in the peripheral part of the display region is larger, the difference between the signal voltage for achieving the maximum brightness (maximum brightness voltage) and the signal voltage for achieving the minimum brightness (minimum brightness voltage) increases, and the drive power of the signal output circuit increases.

Generally, the current driving capacity of a transistor is determined by the input voltage and the ratio (W/L) of the channel width W and the channel length L of the transistor. Therefore, by making the ratio of channel width to channel length larger in the peripheral part of the display region than in the central part, it is possible to increase the current driving capacity of the pixel driving circuit arranged in the peripheral part. Specifically, when the pixel size is four times larger, if the ratio of channel width to channel length is also four times larger, four times the current can be supplied. In this case, in order to increase the current driving capacity of the driving transistor by four times, one driving transistor with a channel width W four times larger may be used, or one driving transistor with a channel length L reduced one-fourth may be used. In addition, a plurality of transistors with the same channel width W and channel length L may be used. In general, due to the influence of the short channel effect and the like, the characteristics of a transistor are not strictly proportional to the ratio of channel width W to channel length L. For this reason, it is desirable to use a plurality of driving transistors of the pixel driving circuits arranged in the peripheral part of the display region that are the same as the driving transistors arranged in the pixel driving circuits in the central part. In that case, it is not necessary to use a plurality of writing transistors, and it may be desirable to use one transistor with the same channel width and channel length in the central part and the peripheral part of the display region.

In addition, it may be preferable that all light-emitting units driven by one pixel driving circuit arranged in the peripheral part of the display region are connected, but it is not necessary that all of them are connected. However, each of the unconnected light-emitting units must be connected to at least one driving transistor.

### Second Embodiment

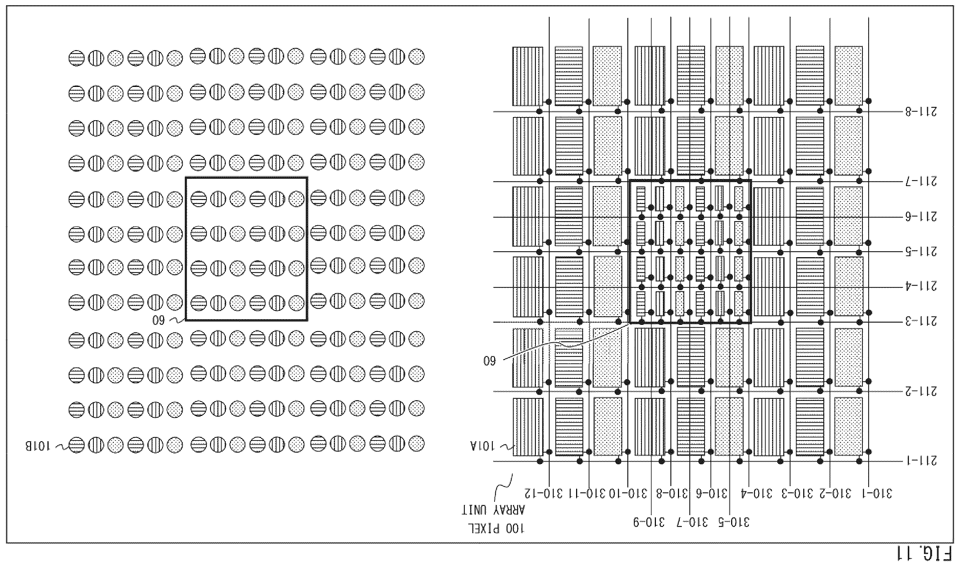

Next, the second embodiment of the present disclosure is shown in FIG. 11. FIG. 11 shows the same arrangement of light-emitting units (red, green, blue from the left) as those shown in FIGS. 8, 9, and 10. On the other hand, the arrangement of the pixel driving circuits is different in the central part 60 of the display region and at least a part of its peripheral part. In addition, the peripheral part is where the arrangement of the light-emitting units (red, green, blue from the left) and the arrangement of the pixel driving circuits (red, blue, green from the left) are different.

In this embodiment, the number of signal lines and write scanning lines in the display region can be reduced, so that it is advantageous in terms of transmission speed and power consumption compared to the conventional case in which pixels of the same size as those in the central part of the display region are arranged in an array over the entire display region.

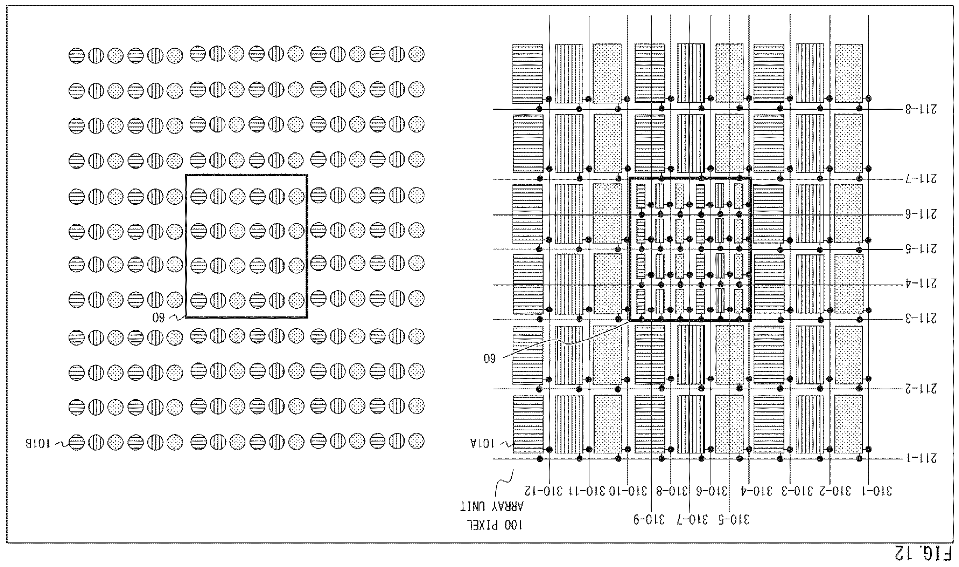

The effect of the configuration of the second embodiment shown in FIG. 11 will be specifically described with reference to FIG. 12 as a comparative example. In FIG. 12, the pixel driving circuits are arranged in the row direction in the order of red (first subpixel), green (second subpixel), and blue (third subpixel) in the entire display region. On the other hand, in FIG. 11, the pixel driving circuits are arranged in the order of red, green, and blue in the central part of the display region, while in at least a part of the peripheral part, they are arranged in the order of red, blue, and green.

In the configuration shown in FIG. 12, in the peripheral part of the display region, red and green light-emitting units are arranged on the pixel driving circuit of the first subpixel (red). In addition, blue and red light-emitting units are arranged on the pixel driving circuit of the second subpixel (green). In addition, green and blue light-emitting units are arranged on the pixel driving circuit of the third subpixel (blue). In contrast, in the configuration shown in FIG. 11, a light-emitting unit for obtaining red emission can be arranged on the pixel driving circuit of the first subpixel (red). A light-emitting unit for obtaining blue emission can be arranged on the pixel driving circuit of the third subpixel (blue). A light-emitting unit for obtaining green emission can be arranged on the pixel driving circuit of the second subpixel (green). Therefore, the arrangement of the pixel driving circuits in the peripheral part of the display region shown in FIG. 11 can reduce the number of light-emitting units of other colors laid out on their own pixel driving circuit compared to the arrangement of the pixel driving circuits shown in FIG. 12. As a result, deterioration in image quality caused by voltage fluctuations of light-emitting units of other colors can be reduced. In addition, in the layout shown in FIG. 11, subpixels connected to a certain signal line (e.g., 310-6) are subpixels of the same color at the central part of the display region and its upper and lower regions. Therefore, it is not necessary to change the color information of the signal voltage output to the signal line between the upper and lower regions of the display region and the central part of the display region. In this way, it is possible to simplify the configuration of the signal output circuit and achieve low power consumption. As described above, the number of subpixels in the peripheral part can be reduced, so that the present embodiment is superior to the conventional one in terms of transmission speed and power consumption.

### Third Embodiment

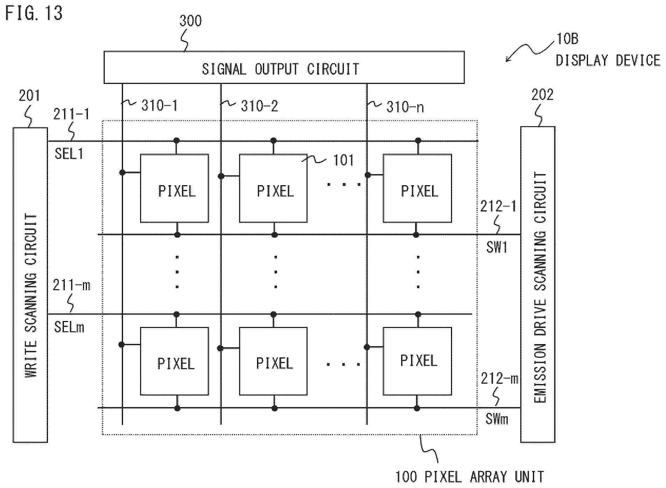

FIG. 13 is a diagram showing an example of a schematic system diagram of an active-matrix-type display device 10B according to the third embodiment of the present disclosure, in which the same parts as those in FIG. 1 are denoted by the same reference numerals. As the pixel 101 in the schematic diagram shown in FIG. 13, a pixel driving circuit having a switching transistor for controlling the emission period as shown in FIG. 3B is preferable.

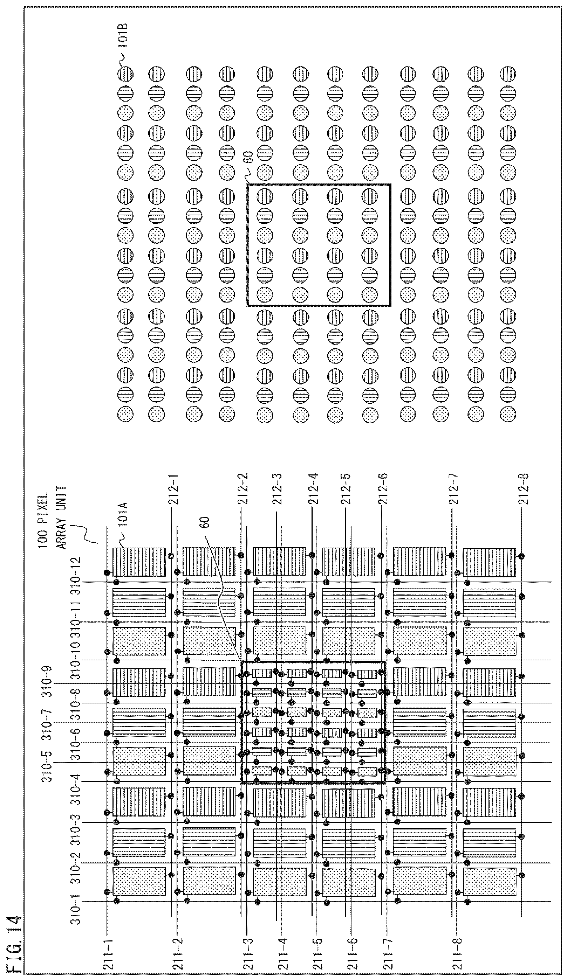

FIG. 14 shows an example of a schematic arrangement of a pixel driving circuit 101A and a light-emitting unit 101B constituting the pixel 101 in the display device 10B shown in FIG. 13.

In the third embodiment, a current-driven display device in which the emission luminance changes according to the current value flowing through the pixel driving circuit (i.e., according to the conduction state) will be described as an example. For example, an active-matrix-type organic EL display device using an organic EL element as the light-emitting element of the pixel (pixel driving circuit) will be described as an example.

In the configuration shown in FIG. 13, second scanning lines 212-1 to 212-m are newly wired for each pixel row along the row direction for the arrangement of pixels 101 in m rows and n columns. The second scanning lines 212-1 to 212-m are respectively connected to the output terminals of the corresponding rows of the emission drive scanning circuit 202.

Like the write scanning circuit 201, the emission drive scanning circuit 202 is also composed of a shift register that shifts a start pulse (not shown) in sequence in synchronization with a clock pulse (not shown). This emission drive scanning circuit 202 supplies emission drive signals SW (SW_1 to SW_m) that drive the pixels 101 to emit light to the second scanning lines in synchronization with the line sequential scanning by the write scanning circuit 201. This emission drive signal SW controls whether the pixels 101 emit light or not.

The second scanning line 212 is connected to the gate of the switching transistor 24 in the pixel driving circuit shown in FIG. 3B. The switching transistor 24 switches between a conduction state and a non-conduction state depending on the potential of the second scanning line 212 (hereinafter, sometimes referred to as the emission drive scanning line 212), and is in a conduction state when emitting light and in a non-conduction state when not emitting light. Displays used in products such as VR and AR generally use an emission control transistor to switch between emission and non-emission within one frame due to the requirement for high video response.

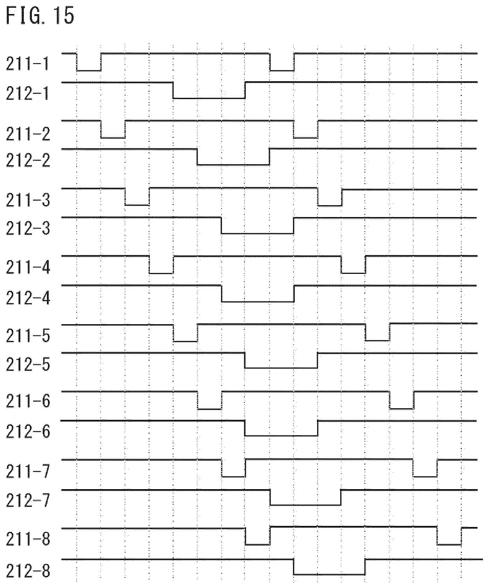

FIG. 15 shows an outline of the driving in this embodiment. FIG. 15 shows the control pulses applied to each scanning line. In the driving shown in FIG. 15, the signals of the emission drive scanning lines connected to the pixel driving circuit in the central part 60 of the display region are synchronized for a plurality of rows (two rows in FIG. 15). As an example of realizing such a configuration, a single shift register may be used for a plurality of rows to form the emission drive scanning circuit 202 to which the emission drive scanning lines 212-3 to 212-6 including the central part 60 of the display region are connected.

The effect of this embodiment will be described. **In** this embodiment, as described above, the central part 60 of the display region emits light in two rows simultaneously. Specifically, in FIG. 15, the emission drive scanning lines 212-3 and 212-4, and 212-5 and 212-6 share the same emission timing. Here, the pixels connected to the emission drive scanning lines 212-3 and 212-5 consist of only six subpixels in the central part 60 of the display region. On the other hand, the pixels connected to the emission drive scanning lines 212-4 and 212-6 consist of six subpixels in the central part 60 of the display region and six subpixels in the peripheral part. For this reason, if the pixels connected to the emission drive scanning lines 212-3 and 212-4 are caused to emit light separately, the number of pixels connected to the emission drive scanning lines will differ, resulting in a variation in the amount of current flowing from the power supply at the start of emission.

Specifically, the pixels connected to the emission drive scanning lines 212-3 and 212-5 correspond to six pixels in terms of the pixel size in the central part 60 of the display region. The pixels connected to the emission drive scanning lines 212-4 and 212-6 correspond to thirty pixels in terms of the pixel size in the central part 60 of the display region. Similarly, the pixels connected to the emission drive scanning lines 212-1, 212-2, 212-7, and 212-8 correspond to thirty-six pixels in terms of the pixel size in the central part 60 of the display region.

The amount of current flowing from the power supply at the start of emission depends on the number of pixels connected to the emission drive scanning lines. Therefore, when considering the pixels connected to the emission drive scanning lines 212-1 to 212-4, the amount of current flowing from the power supply at the start of emission is the largest when the pixels connected to the emission drive scanning lines 212-1 and 2 are caused to emit light. Then, the pixels connected to the emission drive scanning line 212-4 and the pixels connected to the emission drive scanning line 212-3 are caused to emit light, in that order. Due to this amount of current, the fluctuation amount ΔV of the power supply voltage at the start of emission varies for each row. As a result, image quality defects such as unevenness or streaks may occur.

In contrast, in this embodiment, the timing of the emission drive scanning lines 212-3 and 212-4, and 212-5 and 212-6 is set to cause two rows to emit light simultaneously. As described above, the pixels connected to the emission drive scanning lines 212-3 and 212-5 correspond to six pixels in terms of the pixel size in the central part 60 of the display region. The pixels connected to the emission drive scanning lines 212-4 and 212-6 correspond to thirty pixels in terms of the pixel size in the central part 60 of the display region. Therefore, by causing these pixels to emit light simultaneously, the amount of current flowing from the power supply at the start of emission becomes the same as that when the pixels connected to the emission drive scanning lines 212-1 and 2 are caused to emit light. That is, the fluctuation amount ΔV of the power supply voltage at the start of emission does not vary for each row. In this way, it is possible to maintain a constant fluctuation amount of the power supply voltage at the start of emission and obtain uniform image quality without unevenness.

As shown in FIG. 15, the phase difference between the pulse applied to the write scanning line 211-1 of the first row and the pulse applied to the emission drive scanning line 212-1 is different from the phase difference between the pulse applied to the write scanning line 211-8 of the eighth row and the pulse applied to the emission control line 212-8. With this configuration, it is possible to align the current at the start of emission continuously for each horizontal period starting from the first line. As a result, issues such as flickering during video playback, which can occur when row emission becomes discontinuous, are also prevented.

In this embodiment, a plurality of rows of pixels in the central part of the display region are caused to emit light simultaneously, and it is desirable to perform signal writing and correction operations that are generally performed before signal writing on a row-by-row basis.

[Organic Light Emitting Element] Next, an example of an organic light emitting element that can be used in the display device according to the first to third embodiments will be described.

In the display device according to the first to third embodiments, the organic light emitting element has a first electrode, a second electrode, and an organic compound layer arranged between the electrodes. One of the first electrode and the second electrode is an anode and another is a cathode. In the first to third embodiments, as long as the organic compound layer has a light emitting layer, the organic compound layer may be a single layer or may be a laminate including a plurality of layers. Here, in a case where the organic compound layer is the laminate including a plurality of layers, the organic compound layer includes, in addition to the light emitting layer, a hole injection layer, a hole transport layer, an electron blocking layer, a hole-exciton blocking layer, an electron transport layer, an electron injection layer, and the like. In addition, the light emitting layer may be a single layer or a laminate including a plurality of layers. If the light emitting layer is a multi-layer, a charge generation layer may be provided between the light emitting layers. The charge generation layer may be composed of a compound having a lower LUMO than that of the hole transport layer, and the LUMO of the charge generation layer may be lower than a hole transport layer HOMO. Here, a molecular orbital energy of the organic compound layer may be a molecular orbital energy of an organic compound having a largest weight ratio of the organic compound layer.

In the first to third embodiments, in a case where the organic compound is included in the light emitting layer, the light emitting layer may be a layer including only the organic compound or may be a layer including an organometallic complex and another compound. Here, in a case where the light emitting layer is the layer including an organometallic complex and another compound, the organic compound may be used as a host for the light emitting layer or may be used as a guest. In addition, the organic compound may also be used as an assist material that may be included in the light emitting layer. Here, the host is a compound having a largest mass ratio among compounds constituting the light emitting layer. In addition, the guest is a compound, which has a smaller mass ratio than that of the host and is responsible for the main light emission, among the compounds constituting the light emitting layer. In addition, the assist material is a compound, which has a smaller mass ratio than that of the host and assists the light emission of the guest, among the compounds constituting the light emitting layer. Note that the assist material is also referred to as a second host. The host material may also be referred to as a first compound and the assist material may be referred to as a second compound.

Here, the organic compound may, as needed, be used together with conventionally known low-molecular and high-molecular hole-injecting compounds or hole-transporting compounds, host compounds, light-emitting compounds, electron-injecting compounds, electron-transporting compounds, or the like.

As the hole-injecting/transporting material, a material having high hole mobility is preferred so that the injection of holes from the anode is facilitated and the injected holes can be transported to the light emitting layer. Further, in the organic light emitting element, a material having a high glass transition temperature may be preferred to reduce degradation in film quality such as crystallization.

The electron-transporting material may be arbitrarily selected from those capable of transporting electrons injected from the cathode to the light emitting layer, and may be selected in consideration of a balance with the hole mobility of the hole-transporting material, or the like. The electron-transporting material is also suitably used for a hole blocking layer.

The electron-injecting material may be arbitrarily selected from those that allow easy electron injection from the cathode, and the electron-injecting material is selected in consideration of a balance with hole injection properties. The electron-injecting material may also be used in combination with the electron transport material.

[Structure of an Organic Light-Emitting Element] An organic light-emitting element is provided by forming an insulating layer, a first electrode, an organic compound layer, and a second electrode on a substrate. A protective layer, a color filter, a microlens and so forth may be provided on a cathode. In a case where a color filter is provided, a planarization layer may be provided between the color filter and the protective layer. The planarization layer can be, for example, made up of an acrylic resin. The same is true in a case where the planarization layer is provided between the color filter and the microlens.

[Substrate] At least one material selected from quartz, glass, silicon, resins, and metals can be used as the material for the substrate that makes up the organic light-emitting element. Switching elements, such as transistors, and wiring may be provided on the substrate, and an insulating layer may be provided on the foregoing.

Any material can be used as the insulating layer so long as a contact hole can be formed between the insulating layer and the first electrode, and insulation from unconnected wiring can be ensured, so that wiring can be formed between the first electrode and the insulating layer. For example, a resin such as a polyimide, or silicon oxide or silicon nitride can be used herein.

[Electrodes] A pair of electrodes can be used as the electrodes of the organic light-emitting element. The pair of electrodes may be an anode and a cathode. In a case where an electric field is applied in the direction in which the organic light-emitting element emits light, the electrode of higher potential is the anode, and the other electrode is the cathode. Stated otherwise, the electrode that supplies holes to the light-emitting layer is the anode, and the electrode that supplies electrons is the cathode.

A material having a work function as large as possible may be preferable herein as a constituent material of the anode. For example, single metals such as gold, platinum, silver, copper, nickel, palladium, cobalt, selenium, vanadium, or tungsten, and mixtures containing the foregoing metals, can be used in the anode. Also, alloys obtained by combining these single metals, or metal oxides, such as tin oxide, zinc oxide, indium oxide, indium tin oxide (ITO), and indium zinc oxide, may be used in the anode. Conductive polymers such as polyaniline, polypyrrole, and polythiophene can also be used in the anode.

Any of the foregoing electrode materials may be used singly; also, two or more materials may be used concomitantly. The anode may be made up of a single layer, or may be made up of a plurality of layers.

In a case where an electrode of the organic light-emitting element is configured in the form of a reflective electrode, the electrode material can be, for example, chromium, aluminum, silver, titanium, tungsten, molybdenum, or alloys or layered bodies of the foregoing. The above materials can also function as a reflective film not having a role as an electrode. In a case where an electrode of the organic light-emitting element is configured in the form of a transparent electrode, for example an oxide transparent conductive layer of, for example, indium tin oxide (ITO) or indium zinc oxide can be used, although not particularly limited thereto, as the electrode material. The electrodes may be formed by photolithography.

A material having a small work function may be a constituent material of the cathode. For example, alkali metals, such as lithium; alkaline earth metals, such as calcium; single metals; such as aluminum, titanium, manganese, silver, lead; and chromium; and mixtures of the foregoing, may be used herein. Also, alloys obtained by combining these single metals can be used. For example, magnesium-silver, aluminum-lithium, aluminum-magnesium, silver-copper, or zinc-silver can be used. Metal oxides, such as indium tin oxide (ITO), can also be used.

These electrode materials may be used singly as one type, or two or more types can be used concomitantly. Also, the cathode may have a single-layer structure or a multilayer structure. Silver may be preferably used among the foregoing, and more preferably a silver alloy, in order to reduce silver aggregation. Any alloy ratio can be adopted, so long as silver aggregation can be reduced. A ratio of silver to another metal may be, for example, 1:1 or 3:1.

Although not particularly limited thereto, the cathode may be a top emission element that utilizes an oxide conductive layer of ITO or the like, or the cathode may be a bottom emission element that utilizes a reflective electrode of aluminum (Al) or the like. The method for forming the cathode is not particularly limited, but may preferable be, in some embodiments, a DC or AC sputtering method, since in that case film coverage is good and resistance can be readily lowered.

[Pixel Separation Layer] The pixel separation layer of the organic light-emitting element is formed out of a silicon nitride (SiN) film, a silicon oxynitride (SiON) film, or a silicon oxide (SiO) film, in turn having been formed by chemical vapor deposition (CVD). In order to increase the in-plane resistance of the organic compound layer, preferably the thickness of the organic compound layer that is formed, particularly a hole transport layer, may set to be small at the side walls of the pixel separation layer. Specifically, the side walls can be formed to be thin by increasing vignetting at the time of deposition, through an increase of the taper angle of the side walls of the pixel separation layer and/or an increase of the thickness of the pixel separation layer.

On the other hand, it may be preferable to adjust the side wall taper angle of the pixel separation layer and the thickness of the pixel separation layer so that no voids are formed in the protective layer that is formed on the pixel separation layer. The occurrence of defects in the protective layer can be reduced by virtue of the fact that no voids are formed in the protective layer. Since the occurrence of defects in the protective layer is thus reduced, it becomes possible to reduce loss of reliability, for example in terms of the occurrence of dark spots or defective conduction in the second electrode.

The present embodiment allows the effective suppression of leakage of charge to adjacent pixels even when the taper angle of the side walls of the pixel separation layer is not sharp. Studies by the inventors of the present application have revealed that leakage of charge to adjacent pixels can be sufficiently reduced if the taper angle lies in the range at least 60 degrees and not more than 90 degrees. The thickness of the pixel separation layer is preferably at least 10 nm and not more than 150 nm. A similar effect can be achieved also in a configuration having only a pixel electrode lacking a pixel separation layer. In this case, however, it may be preferable to set the film thickness of the pixel electrode to be half or less than a half of the thickness the organic layer, or to impart a forward taper at the ends of the pixel electrode, at a taper angle smaller than 60 degrees, since short circuits of the organic light-emitting element can be reduced thereby.

[Organic Compound Layer (Functional Layer)] The organic compound layer of the organic light-emitting element may be formed out of a single layer or multiple layers. In a case where the organic compound layer has multiple layers, these may be referred to as a hole injection layer, a hole transport layer, an electron blocking layer, a light-emitting layer, a hole blocking layer, an electron transport layer, or an electron injection layer, depending on the function of the layer. The organic compound layer is mainly made up of organic compounds, but may contain inorganic atoms and inorganic compounds. For example, the organic compound layer may have copper, lithium, magnesium, aluminum, iridium, platinum, molybdenum, or zinc. The organic compound layer may be disposed between the first electrode and the second electrode, and the organic compound layer may be disposed in contact with the first electrode and the second electrode.

In the case of multiple light-emitting layers, the first and second light-emitting layers may have a charge generating portion between the first and second light-emitting layers. The charge generating portion may have an organic compound with a lowest unoccupied molecular orbital energy (LUMO) of -5.0 eV or less. The same is true in the case of providing a charge generating section between the second and third light-emitting layers.

[Protective Layer] In the organic light-emitting element of the present embodiment, a protective layer may be provided on the second electrode. For example, intrusion of water or the like into the organic compound layer can be reduced, and the occurrence of display defects also reduced, by bonding a glass provided with moisture absorbance onto the second electrode. As another embodiment, a passivation film of, for example, silicon nitride may be provided on the cathode, to reduce intrusion of water or the like into the organic compound layer. For example, formation of the cathode may be followed by conveyance to another chamber, without breaking a vacuum, whereupon a protective layer may be formed through formation of a silicon nitride film having a thickness of 2 µm by CVD. The protective layer may be provided by atomic deposition (ALD), after film formation by CVD. The material of the film formed by ALD is not limited, but may be, for example, silicon nitride, silicon oxide, or aluminum oxide. Silicon nitride may be further formed, by CVD, on the film having been formed by ALD. The film formed by ALD may be thinner than the film formed by CVD. Specifically, the thickness of the film formed by ALD may be 50% or less, or 10% or less.

[Color Filter] A color filter may be provided on the protective layer of the organic light-emitting element of the present embodiment. For example, a color filter having factored therein the size of the organic light-emitting element may be provided on another substrate, followed by affixing to a substrate having the organic light-emitting element provided thereon; also, a color filter may be patterned by photolithography on the protective layer illustrated above. The color filter may be made up of a polymer.

[Planarization Layer] The organic light-emitting element of the present embodiment may have a planarization layer between the color filter and the protective layer. The planarization layer is provided for the purpose of reducing underlying layer unevenness. The planarization layer may be referred to as a resin layer in a case where the purpose of the planarization layer is not limited. The planarization layer may be made up of an organic compound, which may be a low-molecular or high-molecular compound, preferably a high-molecular compound in some embodiments.

The planarization layer may be provided above and below the color filter, and the constituent materials of the respective planarization layers may be identical or dissimilar. Concrete examples include polyvinylcarbazole resins, polycarbonate resins, polyester resins, ABS resins, acrylic resins, polyimide resins, phenolic resins, epoxy resins, silicone resins, and urea resins.

[Microlens] The display device may have an optical member, such as a microlens, on the light exit side. The microlens may be made of, for example, an acrylic resin or an epoxy resin. The purpose of the microlens may be to increase the amount of light extracted from the display device, and to control the direction of the extracted light. The microlens may have a hemispherical shape. In a case where the microlens has a hemispherical shape, then from among tangent lines that are in contact with the hemisphere there is a tangent line that is parallel to the insulating layer, such that the point of contact between that tangent line and the hemisphere is the apex of the microlens. The apex of the microlens can be established similarly in any cross section. That is, among tangent lines that are in contact with a semicircle of the microlens in a sectional view, there is a tangent line that is parallel to the insulating layer, such that the point of contact between that tangent line and the semicircle is the apex of the microlens.

A midpoint of the microlens can also be defined. Given a hypothetical line segment from the end point of an arc shape to the end point of another arc shape, in a cross section of the microlens, the midpoint of that line segment can be referred to as the midpoint of the microlens. The cross section for discriminating the apex and the midpoint may be a cross section that is perpendicular to the insulating layer.

The microlens has a first surface with a bulge and a second surface on the reverse side from that of the first surface. Preferably, the second surface is disposed closer to a functional layer than the first surface. In adopting such a configuration, the microlens must be formed on the display device. In a case where the functional layer is an organic layer, it is preferable to avoid high-temperature processes in the manufacturing process. If a configuration is adopted in which the second surface is disposed closer to the functional layer than the first surface, the glass transition temperatures of all the organic compounds that make up the organic layer are preferably 100°C or higher, and more preferably 130°C or higher.

[Counter Substrate] The organic light-emitting element of the present embodiment may have a counter substrate on the planarization layer. The counter substrate is so called because it is provided at a position corresponding to the above-described substrate. The constituent material of the counter substrate may be the same as that of the substrate described above. The counter substrate can be used as the second substrate in a case where the substrate described above is used as the first substrate.

[Organic Layer] Each organic compound layer (hole injection layer, hole transport layer, electron blocking layer, light-emitting layer, hole blocking layer, electron transport layer, electron injection layer, and so forth) that makes up the organic light-emitting element of the present embodiment is formed in accordance with one of the methods illustrated below.

A dry process, such as vacuum deposition, ionization deposition, sputtering, plasma or the like, can be used for the organic compound layers that make up the organic light-emitting element of the present embodiment. A wet process in which a layer is formed through dissolution in an appropriate solvent, relying on a known coating method (e.g., spin coating, dipping, casting, LB film deposition to inkjet) can resorted to instead of a dry process.

When a layer is formed, for example, by vacuum deposition or by solution coating, crystallization or the like is less likely to occur; this translates into superior stability over time. In a case where a film is formed in accordance with a coating method, the film can be formed by being combined with an appropriate binder resin.

Examples of binder resins include, although they are not limited to, polyvinylcarbazole resins, polycarbonate resins, polyester resins, ABS resins, acrylic resins, polyimide resins, phenolic resins, epoxy resins, silicone resins, and urea resins.

These binder resins may be used singly as one type, in the form of homopolymers or copolymers; also, two or more types of binder resin may be used in the form of mixtures. Additives such as known plasticizers, antioxidants, and ultraviolet absorbers may be further used concomitantly, as needed.

[Pixel Driving Circuit] A display device having the organic light-emitting element of the present embodiment may have pixel driving circuits connected to respective organic light-emitting elements. The pixel driving circuits may be of active matrix type, and may control independently emission of light by the first organic light-emitting element and the second organic light-emitting element. Active matrix circuits may be voltage-programmed or current-programmed. A display device has a pixel circuit for each pixel. Each pixel circuit may have an organic light-emitting element, a transistor that controls the emission luminance of the organic light-emitting element, a transistor that controls emission timing, a capacitor which holds the gate voltage of the transistor that controls emission luminance, and a transistor for connection to GND bypassing the light-emitting element.

The display device has a display area and a peripheral area disposed around the display area. The display area has pixel driving circuits, and the peripheral area has a display control circuit. The mobility of the transistors that make up the pixel driving circuits may be lower than the mobility of the transistors that make up the display control circuit.

The slope of the current-voltage characteristic of the transistors that make up the pixel driving circuits may be gentler than the slope of the current-voltage characteristic of the transistors that make up the display control circuit. The slope of the current-voltage characteristics can be measured on the basis of a so-called Vg-Ig characteristic.

The transistors that make up the pixel driving circuits are connected to light-emitting elements, such as the first organic light-emitting element.

[Pixels] The display device of the present embodiment has a plurality of pixels. The pixels have sub-pixels that emit mutually different colors. The sub-pixels may have, for example, respective RGB emission colors.

The pixels emit light in a pixel opening region. This region is the same as the first region. The aperture diameter of the pixel openings may be 15 µm or smaller, and may be 5 µm or larger. More specifically, the aperture diameter of the pixel openings may be, for example, 11 µm, or 9.5 µm, or 7.4 µm, or 6.4 µm. The spacing between sub-pixels may be 10 µm or smaller, specifically 8 µm, or 7.4 µm, or 6.4 µm, for example.

The pixels can have any known arrangement in a plan view. For example, the pixel layout may be a stripe arrangement, a delta arrangement, a Pen tile arrangement, or a Bayer arrangement. The shape of the sub-pixels in a plan view may be any known shape. For example, the sub-pixel shape may be, for example, quadrangular, such as rectangular or rhomboidal, or may be hexagonal. Needless to say, the shape of the sub-pixels is not an exact shape, and a shape close to that of rectangle falls under a rectangular shape. Sub-pixel shapes and pixel arrays can be combined with each other.

[Use of the Display Device According to the First to Third Embodiments] The display device according to the first to third embodiments can be used as a constituent member of a variety of equipment and devices. Other uses of the display device include light-emitting devices having color filters, in white light sources.

The display device may be an image information processing device having an image input unit for input of image information, for example from an area CCD, a linear CCD, or a memory card, and an information processing unit for processing inputted information, such that an inputted image is displayed on a display unit. The display unit may include the display device according to any one of the first to third embodiments.

A display unit of an imaging device or of an inkjet printer may have the display device according to any one of the first to third embodiments. The display unit may have a touch panel function. The driving scheme of this touch panel function may be an infrared scheme, a capacitive scheme, a resistive film scheme, or an electromagnetic induction scheme, and is not particularly limited. The display device may also be used in a display unit of a multi-function printer.

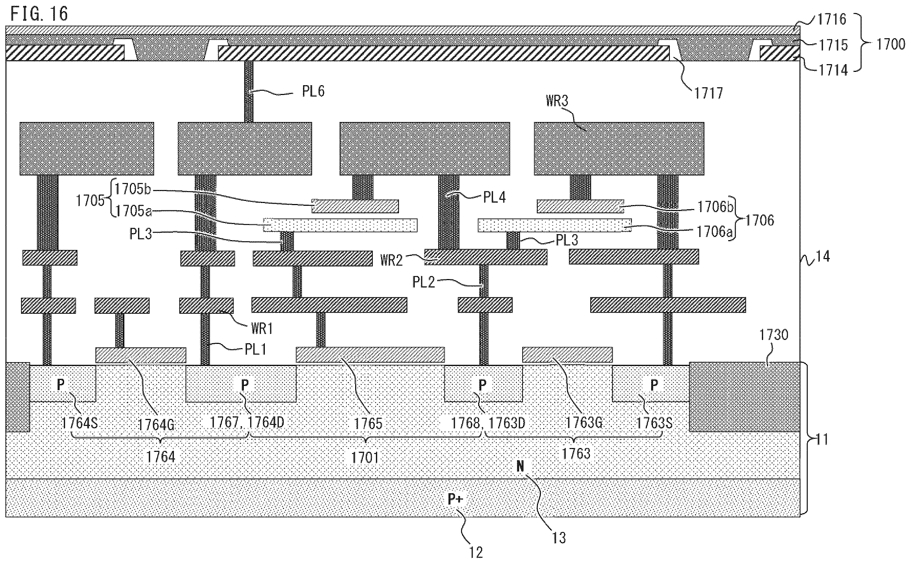

Next, a cross-sectional example of a part of the display device of the first to third embodiments will be described with reference to FIG. 16. Note that for convenience of description, the elements and the like described above may be denoted by different reference numerals.

The display device includes a substrate 11, an insulating layer 14, and a light emitting element 1700. The insulating layer 14 is located on the substrate 11. The light emitting element 1700 is located on the insulating layer 14. In other words, the insulating layer 14 is located between the substrate 11 and the light emitting element 1700.

The substrate 11 has a main surface (upper surface in FIG. 16) on which a drive transistor 1701, a write control transistor 1703, and a light emission control transistor 1702 are formed. The substrate 11 may be formed of, for example, a P-type semiconductor. An N-type well region 13 is formed on the main surface side of the substrate 11 (that is, on the upper side of the substrate 11). A region of the substrate 11 except for the well region 13 becomes a P-type semiconductor region 12.

The substrate 11 has, in the well region 13, a plurality of impurity regions that function as a source region or a drain region of the transistor. The impurity regions may be of P-type conductivity, for example.

A conductive layer 1765, a conductive layer 1763G, and a conductive layer 1764G are disposed on the main surface (upper surface) of the substrate 11. The conductive layer 1763G functions as a gate of the light emission control transistor 1763. One of the P-type impurity regions functions as a source 1763S of the light emission control transistor 1763, and another one of the P-type impurity regions functions as a drain 1763D. The conductive layer 1765 functions as a gate of a drive transistor 1761. The impurity region that functions as the drain 1763D of the light emission control transistor 1763 also functions as a source 1768 of the drive transistor 1701. In addition, one of other P-type impurity regions functions as a drain 1767 of the drive transistor 1701.

Furthermore, the conductive layer 1764G functions as a gate of a reset transistor 1764. In addition, the impurity region that functions as the source 1768 of the drive transistor 1701 also functions as a drain 1764D of the reset transistor 1764. In addition, one of other P-type impurity regions functions as a source 1764S of the reset transistor 1764.

The substrate 11 further includes an element isolation portion 1730 formed between adjacent pixels. As the element isolation portion 1730, shallow trench isolation (STI), local oxidation of silicon (LOCOS) isolation, P-type diffusion layer isolation, and the like may be used.

The light emitting element has a cathode 1716, an organic light emitting layer 1715, and an anode 1714. The cathode 1716 is electrically connected to a power supply line 1708. The anode 1714 is electrically connected to a main terminal (here, the drain) of the drive transistor 1701. The organic light emitting layer 1715 is located between the cathode 1716 and the anode 1714. A bank portion 1717 is disposed at an end of the anode 1714. The bank portion 1717 suppresses leakage of a current flowing between the anode 1714 and the cathode 1716 to adjacent pixels.

A conductive pattern, an electrode of a capacitive element, and a plug are embedded in the insulating layer 14. The insulating layer 14 may be, for example, silicon oxide. Each conductive pattern may be a wiring layer. For example, as illustrated in FIG. 16, the conductive pattern includes a wiring WR1, a wiring WR2, and a wiring WR3.

A capacitive element 1705 has electrodes 1705a and 1705b, and a capacitive element 1706 has electrodes 1706a and 1706b. In the insulating layer 14, the electrodes 1705a and 1706a may be disposed on the same insulating layer. In addition, the electrodes 1705b and 1706b may be disposed on the same insulating layer. The electrodes 1705a and 1705b face each other with an insulating layer interposed therebetween. The electrodes 1706a and 1706b face each other with an insulating layer interposed therebetween. Thus, the capacitive element having a metal-insulator-metal (MIM) structure is configured.

A plurality of plugs include, for example, a plug PL1, a plug PL2, a plug PL3, a plug PL4, and a plug PL5. All of the plurality of plugs may have the same thickness, or may have different thicknesses, or some of the plugs may have the same thickness and some of the plugs may have different thicknesses.

The plug PL1 may connect the wiring WR1 and a terminal (any of a gate, a source, and a drain) of the transistor. The plug PL2 may connect the wiring WR1 and the wiring WR2. A lower electrode of the capacitive element (1705 or 1706) is connected to the drive transistor 1701 via the plug PL3, the wiring WR2, the plug PL2, the wiring WR1, and the plug PL1. In addition, an upper electrode of the capacitive element (1705 or 1706) may be connected to the wiring WR3 via the plug PL5.

The wiring WR3 is connected to the transistor (any of the drive transistor, the current control transistor, and the reset transistor in FIG. 16) via the plug PL4, the wiring R2, the plug PL2, the wiring WR1, and the plug PL1. The anode 1714 may be connected to the drain 1767 of the drive transistor 1701 via the plug PL6, the wiring WR3, the plug PL4, the wiring WR2, the plug PL2, the wiring WR1, and the plug PL1.

The plug may be made in a process separate from the wiring, and may be formed in the same process as the wiring disposed on the plug. For example, the wiring WR2 and the plug PL2 may be formed in the same process and have the same material. In addition, the wiring WR3 and the plug PL4 may be formed in the same process and have the same material. The wiring and the plug are made using a pure metal, such as copper, tungsten, aluminum, and titanium, or an alloy.

In this way, by using a semiconductor substrate as the substrate and using a MOS transistor as the transistor included in each pixel, a denser arrangement can be achieved compared to a case where a thin film transistor is used as the transistor. Therefore, when the display device of the first embodiment includes the semiconductor substrate and the transistor is the MOS transistor, the display device can be further improved in definition or further downsized.

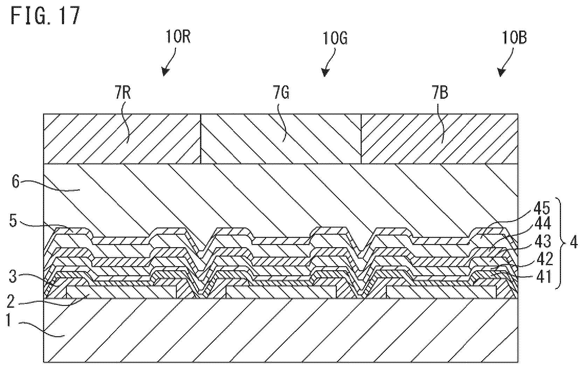

FIG. 17 is a cross-sectional schematic diagram illustrating an example of a display device having organic light-emitting elements and transistors connected to respective organic light-emitting elements. The transistors are an example of active elements. Although the transistors may be thin-film transistors (TFTs) in this example, MOSFET employing a semiconductor substrate may be used for the transistors. By using MOSFETs, the transistors in each pixel can be disposed in a smaller area.

FIG. 17 is an example of a pixel, which is a constituent element of a display device according to any one of the first to third embodiments. The pixel has sub-pixels 10. The sub-pixels are divided into 10R, 10G, and 10B, depending on the respective emission light of the sub-pixel. The emission color may be made different on the basis of the wavelength emitted from the light-emitting layer; also, the light emitted from each sub-pixel may be selectively transmitted or color-converted, for example by a respective color filter. Each sub-pixel has a reflective electrode 2 as a first electrode on an interlayer insulating layer 1, an insulating layer 3 that covers the edge of the reflective electrode 2, an organic compound layer 4 that covers the first electrode and the insulating layer 3, the second electrode 5, a protective layer 6, and color filters 7.

The interlayer insulating layer 1 may have transistors and capacitive elements disposed thereunder or in the interior. The transistors and the first electrode may be electrically connected, for example by way of contact holes (not shown).

The insulating layer 3 is also referred to as a bank or as pixel separation film. The insulating layer 3 is disposed covering the edge of the first electrode while surrounding the first electrode. Portions where the insulating layer is not disposed are in contact with the organic compound layer 4, yielding emission regions.

The organic compound layer 4 has a hole injection layer 41, a hole transport layer 42, a first light-emitting layer 43, a second light-emitting layer 44, and an electron transport layer 45.

The second electrode 5 may be a transparent electrode, a reflective electrode, or a semi-transparent electrode.

The protective layer 6 reduces permeation of moisture into the organic compound layer. The protective layer 6 is illustrated herein in the form of one layer, but may be multiple layers. Each protective layer 6 may have an inorganic compound layer or an organic compound layer.

The color filters 7 are divided into a color filter 7R, a color filter 7G and a color filter 7B, according to the color thereof. The color filters may be formed on a planarization film, not shown. A resin protective layer, not shown, may be provided on the color filters. The color filters may be formed on the protective layer 6. Also, the color filters may be affixed after having been provided on a counter substrate such as a glass substrate.

### Fourth Embodiment

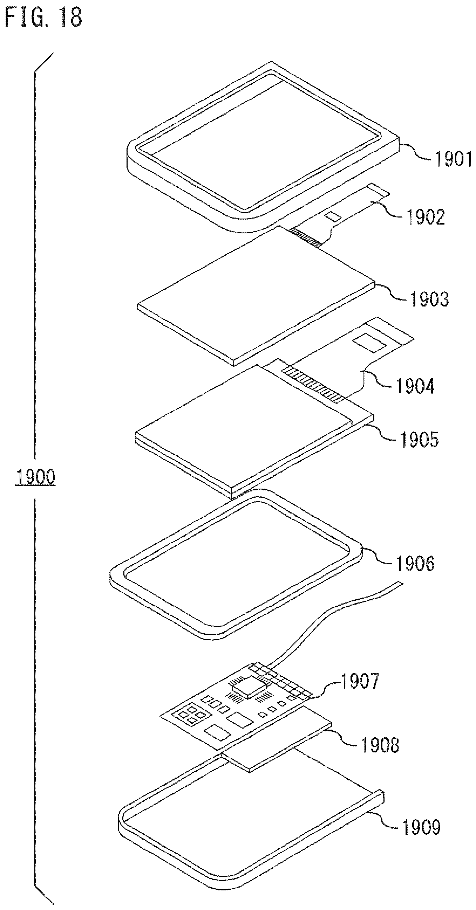

Next, FIG. 18 illustrates a schematic diagram depicting an exploded view of an example of a display device according to any one of the first to third embodiments. A display device 1900 may have a touch panel 1903, a display panel 1905, a frame 1906, a circuit board 1907, and a battery 1908, between an upper cover 1901 and a lower cover 1909. The touch panel 1903 and the display panel 1905 are connected to flexible printed circuits FPCs 1902, 1904.

The display panel 1905 includes the display device according to the first embodiment. Transistors are printed on the circuit board 1907. The battery 1908 may be omitted if the display device is not a portable device; even if the display device is a portable device, the battery 1908 may be provided at a different position.

The display device 1900 may have red, green and blue color filters. The color filters may be disposed in a delta arrangement of the above red, green and blue.

The display device 1900 may be used as a display unit of a mobile terminal. In that case the display device 1900 may have both a display function and an operation function. Mobile terminals include mobile phones such as smartphones, tablets and head-mounted displays.

The display device 1900 may be used in a display unit of an imaging device that has an optical unit having a plurality of lenses and that has an imaging element that receives light having passed through the optical unit. The imaging device may have a display unit that displays information acquired by the imaging element. The display unit may be a display unit exposed outside the imaging device, or the display unit may be a display unit disposed within a viewfinder. The imaging device may be a digital camera or a digital video camera.

### Fifth Embodiment

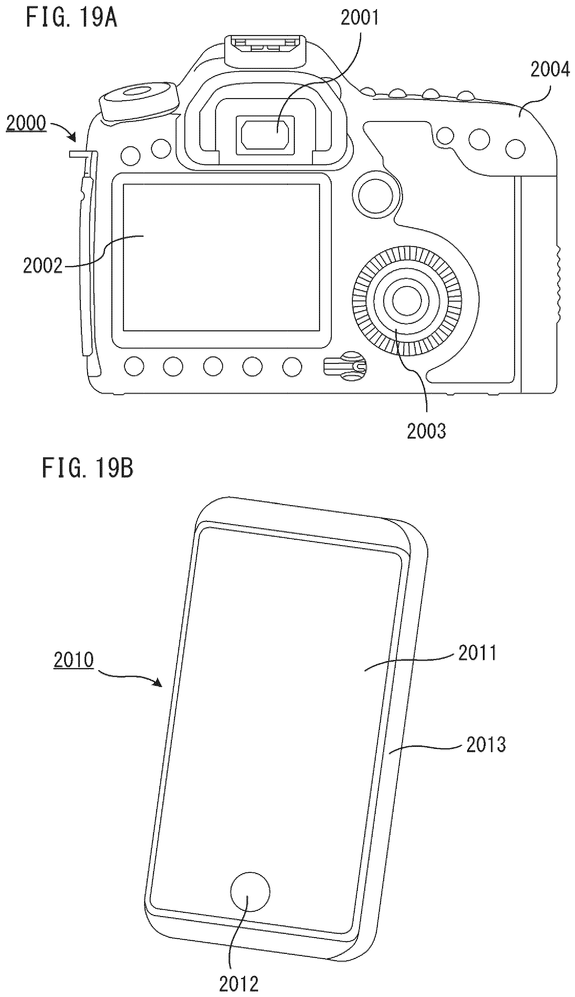

Next, FIG. 19A illustrates a schematic diagram depicting an example of an imaging device according to the present embodiment. An imaging device 2000 may have a viewfinder 2001, a rear display 2002, an operation unit 2003, and a housing 2004. The viewfinder 2001 may have the display device according to the first embodiment. In that case the display device may display not only an image to be captured, but also, for example, environment information and imaging instructions. The environment information may include, for example, external light intensity, external light orientation, the moving speed of a subject, and the chance of the subject being blocked by an obstacle.

The timing suitable for imaging is short, and hence information should be displayed as soon as possible. It is therefore preferable to configure the display device so as to have a high response speed, using the organic light-emitting element. A display device that utilizes the organic light-emitting element can be utilized more suitably than these devices or liquid crystal display devices, where high display speed is required.

The imaging device 2000 has an optical unit, not shown. The optical unit has a plurality of lenses, and the optical unit forms an image on an imaging element accommodated in the housing 2004. The lenses can be focused through adjustment of the relative positions thereof. This operation can also be performed automatically. The imaging device may be referred to as a photoelectric conversion device. The photoelectric conversion device can encompass, as an imaging method other than sequential imaging, a method that involves detecting a difference relative to a previous image, and a method that involves cutting out part of a recorded image.

### Sixth Embodiment

FIG. 19B is a schematic diagram illustrating an example of an electronic apparatus according to the present embodiment. An electronic apparatus 2010 includes a display unit 2011, an operation unit 2012, and a housing 2013. The housing 2013 may have a circuit, a printed board having the circuit, a battery, and a communication unit.

The display unit may include the display device according to the first embodiment. The operation unit 2012 may be a button or a touch panel-type reaction unit. The operation unit 2012 may be a biometric recognition unit which, for example, performs unlocking upon recognition of a fingerprint. The electronic apparatus having a communication unit can also be referred to as a communication device. The electronic apparatus 2010 may further have a camera function, by being provided with a lens and an imaging element. Images captured by way of the camera function are displayed on the display unit. Examples of the electronic apparatus include smartphones and notebook computers.

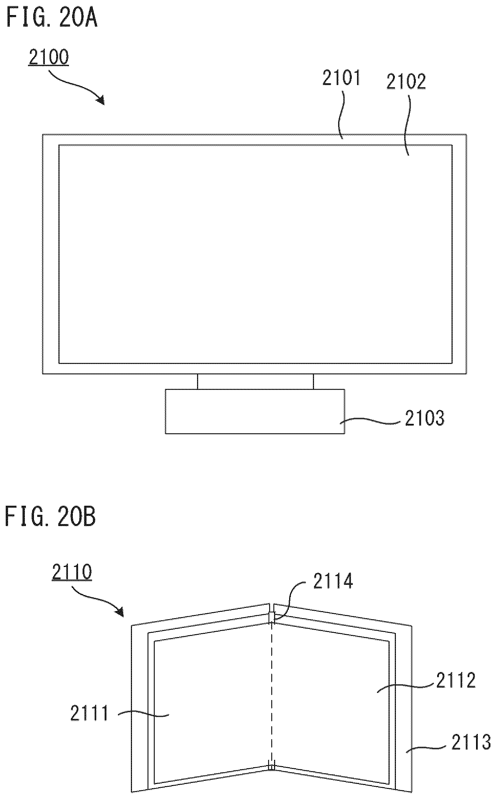

Next, FIG. 20A illustrates a schematic diagram depicting an example of an electronic apparatus according to the present embodiment. FIG. 20A illustrates a display device 2100, such as a television monitor or PC monitor. The display device 2100 has a frame 2101 and a display unit 2102. The display unit 2102 may use the display device according to the first embodiment.

The display device 2100 also has the frame 2101 and a base 2103 that supports the display unit 2102. The form of the base 2103 is not limited to the form in FIG. 20A. The lower side of the frame 2101 may also double as the base.

The frame 2101 and the display unit 2102 may be curved. The radius of curvature of the foregoing may be at least 5000 mm and not more than 6000 mm.

FIG. 20B is a schematic diagram illustrating another example of an electronic apparatus according to the present embodiment. A display device 2110 in FIG. 20B is a foldable display device, configured to be foldable. The display device 2110 has a first display unit 2111, a second display unit 2112, a housing 2113, and a folding point 2114. The first display unit 2111 and the second display unit 2112 may have the display device according to the first embodiment. The first display unit 2111 and the second display unit 2112 may be one seamless display device. The first display unit 2111 and the second display unit 2112 can be separated at the folding point. The first display unit 2111 and the second display unit 2112 may display different images; also, the first display unit and the second display unit may display one image.

### Seventh Embodiment

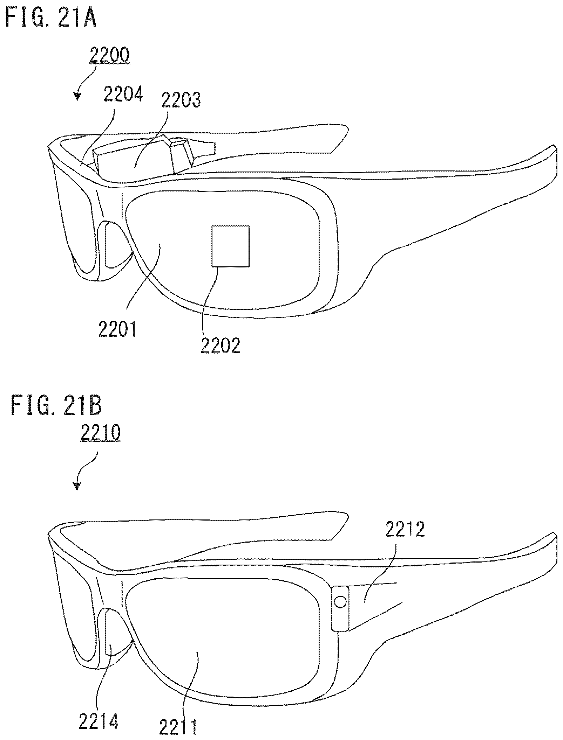

Next, application examples of the display devices according to the first to third embodiments are described referring to FIGS. 21A and 21B. Display devices may be applied to systems that may be worn as wearable devices, such as smart glasses, HMDs, and smart contacts, for example. The imaging device and display device used in such application examples may be an imaging device capable of photoelectrically converting visible light and a display device capable of emitting visible light.

FIG. 21A illustrates spectacles 2200 (smart glasses) according to an application example of the display device of the present disclosure. An imaging device 2202 such as a CMOS sensor or a SPAD is provided on the front surface side of a lens 2201 of the spectacles 2200. A display device 2204 according to any one of the first to third embodiments is provided on the back surface side of the lens 2201.

The spectacles 2200 further have a control device 2203. The control device 2203 functions as a power supply that supplies power to the imaging device 2202 and to the display device 2204. The control device 2203 controls the operations of the imaging device 2202 and of the display device 2204. The lens 2201 has formed therein an optical system for condensing light onto the imaging device 2202.

FIG. 21B illustrates spectacles 2210 (smart glasses) according to another application example of the display device of the present disclosure. The spectacles 2210 have a control device 2212. The control device 2212 has mounted therein an imaging device corresponding to the imaging device 2202 and a display device 2214 corresponding to the display device 2204. In a lens 2211 there is formed an optical system for projecting the light emitted by the display device in the control device 2212, such that an image is projected onto the lens 2211. The control device 2212 functions as a power supply that supplies power to the imaging device and to the display device 2214, and the control device 2212 controls the operations of the imaging device and of the display device 2214.

The control device 2212 may have a line-of-sight detection unit that detects the line of sight of the wearer. Infrared rays may be used herein for line-of-sight detection. An infrared light-emitting unit emits infrared light towards one eyeball of a user who is gazing at a display image. The infrared light emitted is reflected by the eyeball and is detected by an imaging unit having a light-receiving element, whereby a captured image of the eyeball is obtained as a result. Impairment of the appearance of the image is reduced herein by having a reducing means for reducing light from the infrared light-emitting unit to the display unit, in a plan view.

The line of sight of the user with respect to the display image is detected on the basis of the captured image of the eyeball obtained through infrared light capture. Any known method can be adopted for line-of-sight detection using the captured image of the eyeball. As an example, a line-of-sight detection method can be resorted to that utilizes Purkinje images obtained through reflection of irradiation light on the cornea.

More specifically, line-of-sight detection processing based on a pupillary-corneal reflection method is carried out herein. The line of sight of the user is detected by calculating a line-of-sight vector that represents the orientation (rotation angle) of the eyeball, on the basis of a Purkinje image and a pupil image included in the captured image of the eyeball, in accordance with a pupillary-corneal reflection method.

The spectacles 2210 may have an imaging device having a light-receiving element, and may control the display image of the display device on the basis of line-of-sight information about the user, from the imaging device.

Specifically, a first visual field area gazed at by the user and a second visual field area, other than the first visual field area, are determined in the display device 2214 on the basis of line-of-sight information. The first visual field area and the second visual field area may be determined by the control device of the spectacles 2210; also, the display device may receive visual field areas determined by an external control device. In a display area of the display device 2214, the display resolution in the first visual field area may be controlled to be higher than the display resolution in the second visual field area. That is, the resolution in the second visual field area may set to be lower than that of the first visual field area.

The display area may have a first display area and a second display area different from the first display area, such that the display device selects the area of higher priority, from among the first display area and the second display area, on the basis of the line-of-sight information. The first display area and the second display area may be determined by the control device of the display device; also, the display device may receive display areas determined by an external control device. The display device may control the resolution in a high-priority area so as to be higher than the resolution in areas other than high-priority areas. That is, the display device may lower the resolution in areas of relatively low priority.

Herein AI (Artificial Intelligence) may be used to determine the first visual field area and high-priority areas. The AI may be a model constructed to estimate, from an image of the eyeball, a line-of-sight angle and the distance to an object lying ahead in the line of sight, using training data in the form of the image of the eyeball and the direction towards which the eyeball in the image was actually gazing at. An AI program may be provided in the display device, in the imaging device, or in an external device. In a case where an external device has the AI program, the AI program is transmitted to the display device via communication from the external device.

In a case where the display device performs display control on the basis of on visual recognition detection, the display device can be preferably used in smart glasses further having an imaging device that captures images of the exterior. The smart glasses can display captured external information in real time.

### Eighth Embodiment

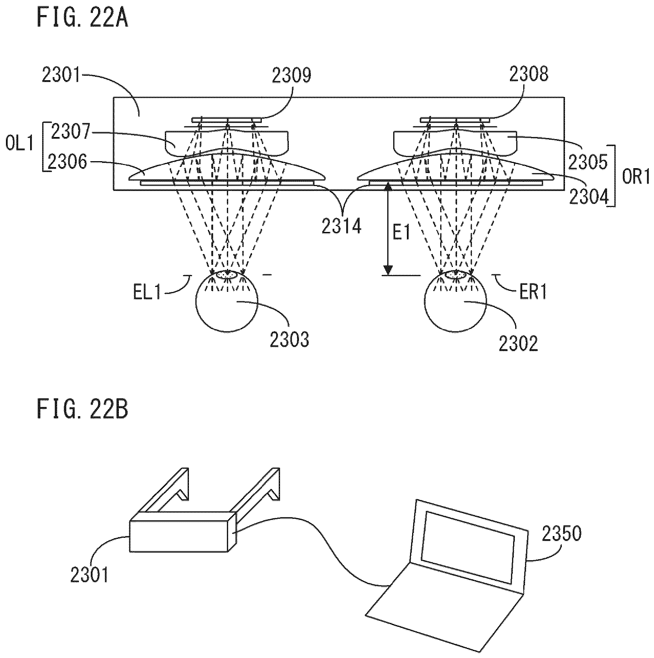

FIG. 22A is a diagram illustrating a configuration of an HMD (head mounted display) 2301 as an image observation device according to the eighth embodiment. The HMD 2301 is worn on the head of the viewer. Reference numeral 2302 denotes the right eye of the observer, and reference numeral 2303 denotes the left eye of the observer. The display lenses 2304 and 2305 constitute the eyepiece optical system OR1 for the right eye, and the display lenses 2306 and 2307 constitute the eyepiece optical system OL1 for the left eye. Each eyepiece optical system is a coaxial optical system including a plurality of (two) display lenses. The right eye 2302 of the observer is disposed on the exit pupil ER1 of the right eyepiece optical system OR1, and the left eye 2303 of the observer is disposed on the exit pupil EL1 of the left eyepiece optical system OL1. The exit pupil ER1 is provided at a position away from the right eyepiece optical system OR1 by a distance E1. Similarly, the exit pupil EL1 is provided at a position away from the left eyepiece optical system OL1 by a distance E1. Optical films 2314 for lens protection, light collection, and the like are provided on the surface of the right eyepiece optical system OR1 (the surface on the right eye 2302 side) and the surface of the left eyepiece optical system OL1 (the surface on the left eye 2303 side).

Reference numerals 2308 and 2309 denote a display device for the right eye and a display device for the left eye, respectively. These display devices may be the display devices according to the first embodiment. FIG. 22B is a diagram illustrating an appearance of the HMD 2301 and a personal computer 2350 connected thereto. Each display device displays a display image (original image) corresponding to an image signal output from the personal computer 2350. In the present embodiment, the connection is achieved in a wired manner, but the connection may be achieved in a wireless manner. The HMD 2301 may be a device that incorporates an image processing apparatus and operates in a stand-alone mode.

The eyepiece optical systems OR1 and OL1 guide the light from the display devices 2308 and 2309 to the exit pupils ER1 and EL1, respectively, thereby projecting the enlarged virtual image of the display image to the right eye 2302 and the left eye 2303 of the viewer. Accordingly, the observer can observe (virtual images of) the display images displayed on the display devices 2308 and 2309 through the eyepiece optical systems OR1 and OL1.

Although not shown, the HMD 2301 may include a controller. The control device functions as a power source for supplying electric power to the display devices 2308 and 2309, and controls the operation of the display devices 2308 and 2309.

The control device may include a line-of-sight detection unit that detects a line of sight of the wearer. The gaze may be detected using infrared light. The infrared light emitting unit emits infrared light to the eyeball of the user who is gazing at the display image. A captured image of the eyeball is obtained by detecting reflected light of the emitted infrared light from the eyeball by an imaging unit having a light receiving element. The reduction unit configured to reduce light from the infrared light emitting unit to the display unit in a plan view reduces degradation in image quality.

The gaze of the user with respect to the display image is detected from the captured image of the eyeball obtained by capturing the infrared light. Any known technique may be applied to the gaze detection using the captured image of the eyeball. As an example, a gaze detection method based on a Purkinje image due to reflection of irradiation light on the cornea can be used.

More specifically, the line-of-sight detection process based on the pupillary corneal reflection method is performed. The gaze of the user is detected by calculating a gaze vector representing the orientation (rotation angle) of the eyeball based on the image of the pupil included in the captured image of the eyeball and the Purkinje image using the pupil corneal reflex method.

Specifically, the display devices 2308 and 2309 determine a first display region to be gazed by the user and a second display region other than the first display region based on the line-of-sight information. The first display region and the second display region may be determined by the control device or may be received by an external control device. In the display regions of the display devices 2308 and 2309, the display resolution of the first display region may be controlled to be higher than the display resolution of the second display region. That is, the resolution of the second display region may be lower than that of the first visibility region.

The display region includes a first display region and a second display region different from the first display region, and a region with a higher priority is determined from the first display region and the second display region based on the line-of-sight information. The first display region and the second display region may be determined by a control device of the display device or may be received by an external control device. The resolution of the high priority region may be controlled to be higher than the resolution of the region other than the high priority region. That is, the resolution of the region having a relatively low priority may be lowered.

Note that AI may be used to determine the first display region or the region with high priority. AI may be a model configured to estimate the angle of the line of sight and the distance to the target object ahead of the line of sight from the image of the eyeball using the image of the eyeball and the direction in which the eyeball of the image is actually viewed as teacher data. The AI program may be included in the display device, the imaging device, or the external device. In a case where the external device has the information, the information is transmitted to the display device via communication.

As described above, the display device according to any one of the first to third embodiments may be applied to various photoelectric conversion device products, electronic apparatuses, and the like according to the present embodiment.

The embodiments described above may be appropriately modified without departing from the technical ideas. Note that the disclosure of the present specification includes not only the matters described in the present specification but also all matters that may be grasped from the present specification and the drawings attached to the present specification.

According to the present disclosure, differences in characteristics such as the emission efficiency and lifespan of organic EL elements in the display region can be reduced, and image quality defects such as unevenness and burn-in can be suppressed.

While the present disclosure has described exemplary embodiments, it is to be understood that some embodiments are not limited to the disclosed exemplary embodiments. The scope of the following claims is to be accorded the broadest interpretation so as to encompass all such modifications and equivalent structures and functions.

## Claims

1. A display device comprising:
a plurality of scanning lines extending in a first direction in a plan view of a main surface of a substrate;
a plurality of signal lines extending in a second direction intersecting the first direction in the plan view; and
a display region in which a plurality of pixels are arranged two-dimensionally, wherein
each of the plurality of pixels respectively has a light-emitting element and a pixel driving circuit for driving the light-emitting element,
the light-emitting element has a light-emitting unit in which an organic layer having a light-emitting layer is sandwiched between a first electrode and a second electrode within an opening in an insulating layer,
the pixel driving circuit has a writing transistor connected to the signal lines and the scanning lines and has a driving transistor for supplying a current to the light-emitting element in response to a signal voltage supplied from the writing transistor,
in one pixel of the plurality of pixels, a region surrounded by a signal line and a scanning line connected to the writing transistor, a signal line connected to a writing transistor of a pixel adjacent to the signal line with the driving transistor sandwiched therebetween, and a scanning line connected to a writing transistor of a pixel adjacent to the scanning line with the driving transistor sandwiched therebetween, is defined as a driving region of the pixel,
the plurality of pixels include a first pixel and a second pixel arranged at a position closer to a center of the display region than the first pixel, and
in the plan view, a ratio of an area of the driving region of the first pixel to an area of the driving region of the second pixel is greater than a ratio of an area of one light-emitting unit of the first pixel to an area of one light-emitting unit of the second pixel.

2. The display device according to claim 1**,** wherein light emitted from the first pixel and light emitted from the second pixel have the same color.

3. The display device according to claim 1 or 2, wherein an area of one light-emitting unit of the first pixel and an area of one light-emitting unit of the second pixel are equal.

4. The display device according to any one of claims 1 to 3, wherein the number of light-emitting units of the first pixel is greater than the number of light-emitting units of the second pixel.

5. The display device according to any one of claims 1 to 4, wherein the first pixel is arranged at a distance of 5% or less from the center of the display region with respect to a distance from the center to an edge of the display region.

6. The display device according to any one of claims 1 to 5, wherein the second pixel is arranged at a distance of 25% or less from an edge of the display region with respect to a distance from an edge to the center of the display region.

7. The display device according to any one of claims 1 to 6, wherein
the display region has a central part having the second pixel and a peripheral part arranged around the central part and having the first pixel, and
in the peripheral part, the light-emitting unit of a pixel that emits light of a first color, the light-emitting unit of a pixel that emits light of a second color different from the first color, and the light-emitting unit of a pixel that emits light of a third color different from the light of the first color and the light of the second color are continuous in a column direction, and an arrangement of the light-emitting units in the central part is the same as that of the light-emitting units in the peripheral part.

8. The display device according to any one of claims 1 to 7, wherein
the display region has a first region, a second region, and a third region between the first region and the second region in the first direction, and a fourth region adjacent to the third region in the second direction,
the first pixel is arranged in the third region and the second pixel is arranged in the fourth region, and
a pitch of signal lines connected to a writing transistor of a pixel arranged in the third region including the first pixel is equal to a pitch of signal lines connected to a writing transistor of a pixel arranged in the fourth region including the second pixel.

9. The display device according to claim 7 or 8, wherein, in the peripheral part of the display region, a light-emitting unit that emits light of a second color different from a first color is arranged on at least a part of a pixel driving circuit of a pixel that emits light of the first color.

10. The display device according to any one of claims 1 to 9, wherein an arrangement of a plurality of the light-emitting units and an arrangement of a plurality of the pixel driving circuits corresponding to the light-emitting units are different in a plurality of pixels arranged in the peripheral part of the display region among the plurality of pixels.

11. The display device according to any one of claims 1 to 10, wherein the number of driving transistors in the first pixel is greater than the number of writing transistors.

12. The display device according to any one of claims 1 to 11, wherein the number of driving transistors in the first pixel is greater than the number of driving transistors in the second pixel.

13. The display device according to any one of claims 1 to 12, wherein the driving transistor in the first pixel has the same channel width and channel length as the driving transistor in the second pixel.

14. The display device according to any one of claims 1 to 13, further comprising a switching transistor that determines whether or not to supply a current to the light-emitting element depending on a conduction state of the pixel driving circuit, wherein the second pixel simultaneously supplies a current to the light-emitting element in a plurality of rows.

15. The display device according to any one of claims 1 to 14, wherein, in the plan view, an area of the driving region of the second pixel is smaller than an area of the driving region of the first pixel.

16. A display device comprising:
a plurality of scanning lines extending in a first direction in a plan view of a main surface of a substrate;
a plurality of signal lines extending in a second direction intersecting the first direction in the plan view; and
a display region in which a plurality of pixels are arranged two-dimensionally, wherein
each of the plurality of pixels has a light-emitting element and a pixel driving circuit for driving the light-emitting element,
the light-emitting element has a light-emitting unit in which an organic layer having a light-emitting layer is sandwiched between a first electrode and a second electrode within an opening in an insulating layer,
the pixel driving circuit has a writing transistor connected to the signal lines and the scanning lines and has a driving transistor for supplying a current to the light-emitting element in response to a signal voltage supplied from the writing transistor,
in one pixel of the plurality of pixels, a region surrounded by a signal line and a scanning line connected to the writing transistor, a signal line connected to a writing transistor of a pixel adjacent to the signal line with the driving transistor sandwiched therebetween, and a scanning line connected to a writing transistor of a pixel adjacent to the scanning line with the driving transistor sandwiched therebetween, is defined as a driving region of the pixel,
the plurality of pixels include a first pixel and a second pixel arranged at a position closer to a center of the display region than the first pixel, and
in the plan view, a ratio of an area of one light-emitting unit of the pixel to an area of the driving region in the first pixel is smaller than a ratio of an area of one light-emitting unit of the pixel to an area of the driving region of the second pixel.

17. The display device according to claim 16, wherein an area of one light-emitting unit of the first pixel and an area of one light-emitting unit of the second pixel are equal.

18. The display device according to claim 16 or 17, wherein the number of light-emitting units of the first pixel is greater than the number of light-emitting units of the second pixel.

19. The display device according to any one of claims 16 to 18, wherein in a peripheral part of the display region, the light-emitting unit of a pixel that emits light of a first color, the light-emitting unit of a pixel that emits light of a second color different from the first color, and the light-emitting unit of a pixel that emits light of a third color different from the light of the first color and the light of the second color are continuous in a column direction, and an arrangement of the light-emitting units in the peripheral part is the same as that of the light-emitting units in the central part.

20. The display device according to any one of claims 16 to 19, wherein
the display region has a first region, a second region, and a third region between the first region and the second region in the first direction, and a fourth region adjacent to the third region in the second direction,
the first pixel is arranged in the third region,
the second pixel is arranged in the fourth region, and
a pitch of signal lines connected to a writing transistor of a pixel arranged in the third region including the first pixel is equal to a pitch of signal lines connected to a writing transistor of a pixel arranged in the fourth region including the second pixel.

21. The display device according to claim 19 or 20, wherein, in the peripheral part of the display region, a light-emitting unit that emits light of a second color different from a first color is arranged on at least a part of a pixel driving circuit of a pixel that emits light of the first color.

22. A photoelectric conversion device comprising:
an optical unit;
an imaging element that receives light that has passed through the optical unit; and
a display device that displays an image captured by the imaging element, wherein
the display device is the display device according to any one of claims 1 to 21.

23. An electronic apparatus comprising:
the display device according to any one of claims 1 to 21;
a housing in which the display device is provided; and
a communication unit provided in the housing to communicate with an external device.
